Europäisches Patentamt

European Patent Office

Office européen des brevets

(19)

(11) **EP 1 521 374 A1**

(12) **EUROPEAN PATENT APPLICATION**

(43) Date of publication:
**06.04.2005 Bulletin 2005/14**

(51) Int Cl.$^7$: **H03M 13/29**

(21) Application number: **04251723.5**

(22) Date of filing: **25.03.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **30.09.2003 JP 2003339003**

(71) Applicant: **FUJITSU LIMITED**
**Kawasaki-shi, Kanagawa 211-8588 (JP)**

(72) Inventor: **Tanaka, Yoshinori c/o Fujitsu Limited**
**Kawasaki-shi, Kanagawa 211-8588 (JP)**

(74) Representative: **Stebbing, Timothy Charles**
**Haseltine Lake & Co.,**
**Imperial House,**
**15-19 Kingsway**
**London WC2B 6UD (GB)**

(54) **Maximum a posteriori probability (MAP) decoding**

(57) In a maximum a posteriori probability (MAP) decoding method for executing decoding processing by a sliding window scheme, encoded data is divided into blocks each of a prescribed length, backward probabilities are obtained in present decoding processing of respective ones of the blocks, and these backward probabilities at initial positions of other blocks are stored in a storage unit (26,28) as initial values of backward probabilities of the other blocks in decoding processing to be executed next. Backward-probability calculation units (23,24) start calculation of backward probability of each block using the stored initial value.

*FIG. 4*

Printed by Jouve, 75001 PARIS (FR)

EP 1 521 374 A1

**Description**

This invention relates to a maximum a posteriori probability (MAP) decoding method and to a decoding apparatus that employs this decoding method. More particularly, the invention relates to a maximum a posteriori probability decoding method and apparatus for implementing maximum a posteriori probability decoding.

Error correction codes, which are for the purpose of correcting errors contained in received information or in reconstructed information so that the original information can be decoded correctly, are applied to a variety of systems. For example, error correction codes are applied in cases where data is to be transmitted without error when performing mobile communication, facsimile or other data communication, and in cases where data is to be reconstructed without error from a large-capacity storage medium such as a magnetic disk or CD.

Among the available error correction codes, it has been decided to adopt turbo codes (see the specification of USP 5,446,747) for standardization in 3rd-generation mobile communications. Maximum a posteriori probability decoding (MAP decoding) manifests its effectiveness in such turbo codes. A MAP decoding method is a method of decoding that resembles Viterbi decoding.

(a) Convolutional encoding

Viterbi decoding is a method of decoding a convolutional code.

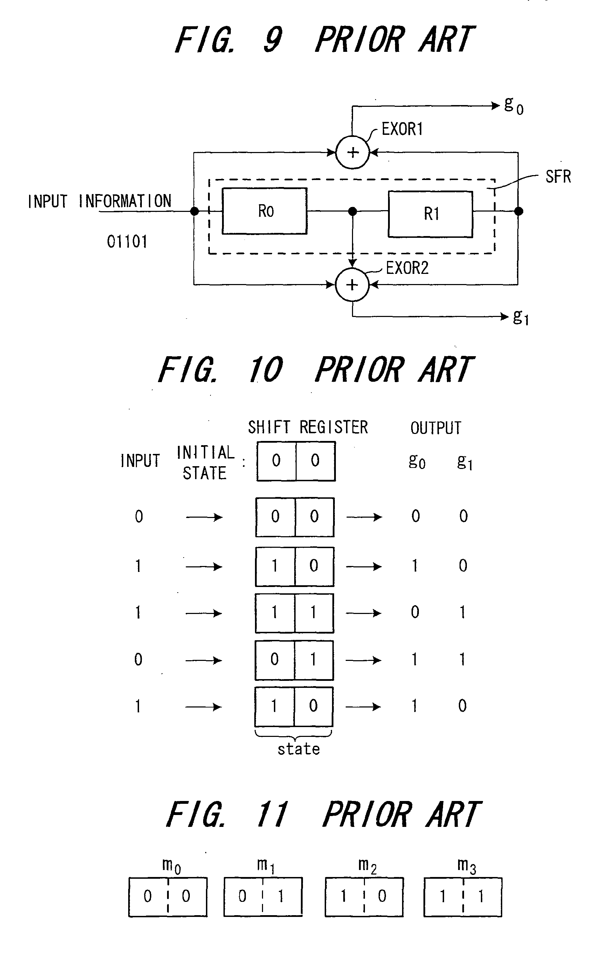

Fig. 9 shows an example of a convolutional encoder, which has a 2-bit shift register SFR and two exclusive-OR gates EXOR1, EXOR2. The gate EXOR1 outputs the exclusive-OR $g_0$ between an input and $R_1$, and the gate EXOR2 outputs the exclusive-OR $g_1$ (outputs "1"when the sum is odd and outputs "0" otherwise) between the input and $R_0$, $R_1$. Accordingly, the relationship between the input and outputs of the convolutional encoder and the states of the shift register SFR in an instance where the input data is 01101 are as illustrated in Fig. 10.

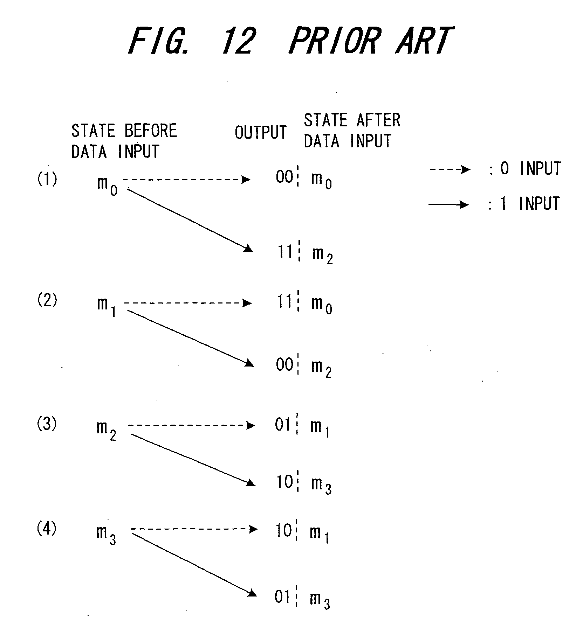

The content of the shift register SFR of the convolutional encoder is defined as its "state". As shown in Fig. 11, there are four states, namely 00, 01, 10 and 11, which are referred to as state $m_0$, state $m_1$, state $m_2$ and state $m_3$, respectively. With the convolutional encoder of Fig. 9, the outputs $(g_0,g_1)$ and the next state are uniquely defined depending upon which of the states $m_0$ to $m_3$ is indicated by the state of the shift register SFR and depending upon whether the next item of input data is "0" or "1". Fig. 12 is a diagram showing the relationship between the states of the convolutional encoder and the inputs and outputs thereof, in which the dashed lines indicate a "0" input and the solid lines a "1" input.

(1) If "0" is input in state $m_0$, the output is 00 and the state is $m_0$; if "1" is input, the output is 11 and the state becomes $m_2$.
(2) If "0" is input in state $m_1$, the output is 11 and the state is $m_0$; if "1" is input, the output is 00 and the state becomes $m_2$.
(3) If "0" is input in state $m_2$, the output is 01 and the state becomes $m_1$; if "1" is input, the output is 10 and the state becomes $m_3$.
(4) If "0" is input in state $m_3$, the output is 10 and the state becomes $m_1$; if "1" is input, the output is 01 and the state becomes $m_3$.

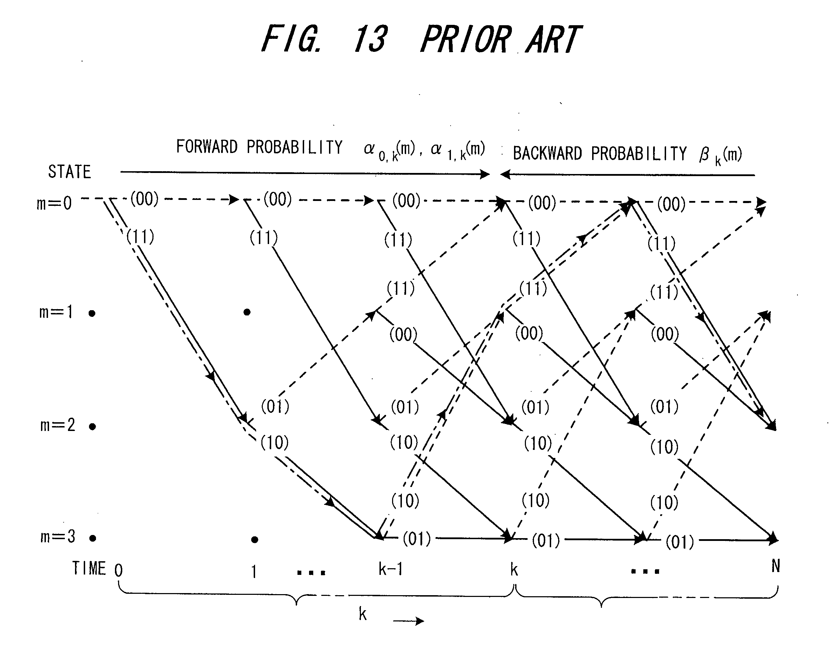

If the convolutional codes of the convolutional encoder shown in Fig. 9 are expressed in the form of a trellis using the above input/output relationship, the result is as shown in Fig. 13, where state $m_i$ (i = 0 to 3) is expressed as state m = 0 to 3, k signifies the time at which a kth bit is input, and the initial (k=0) state of the encoder is m=0. The dashed line indicates a "0" input and the solid line a "1" input, and the two numerical values on the lines indicate the outputs $(g_0, g_1)$. Accordingly, it will be understood that if "0" is input in the initial state m=0, the output is 00 and the state is state m=0, and that if "1" is input, the output is 11 and the state becomes m=2.

Upon referring to this lattice-like representation (a trellis diagram), it will be understood that if the original data is 11001, then state m=2 is reached via the path indicated by the dot-and-dash line in Fig. 13 and the outputs $(g_0, g_1)$ of the encoder become

$$11 \rightarrow 10 \rightarrow 10 \rightarrow 11 \rightarrow 11$$

Conversely, when decoding is performed, if data is received in the order $11 \rightarrow 10 \rightarrow 10 \rightarrow 11 \rightarrow 11$ as receive data (ya,yb), the receive data can be decoded as 11001 by tracing the trellis diagram from the initial state m=0.

(b) Viterbi decoding

If encoded data can be received without error, then the original data can be decoded correctly without difficulty. However, there are cases where data changes from "1" to "0" or from "0" to "1" during the course of transmission and data that contains an error is received as a result. One method that makes it possible to perform decoding correctly in such case is Viterbi decoding.

Using a kth item of data of encoded data obtained by encoding information of information length N, Viterbi decoding selects, for each state (m=0 to m=3) prevailing at the moment of input of the kth item of data, whichever of two paths that lead to the state has the fewer errors, discards the path having many errors, thenceforth, and in similar fashion, selects, for each state prevailing at the moment of input of a final Nth item of data, whichever of two paths that lead to the state has the fewer errors, and performs decoding using the paths of fewest errors among the paths selected at each of the states. The result of decoding is a hard-decision output.

With Viterbi decoding, the paths of large error are discarded in each state and these paths are not at all reflected in the decision regarding paths of fewest errors. Unlike Viterbi decoding, MAP decoding is such that even a path of many errors in each state is reflected in the decision regarding paths of fewest errors, whereby decoded data of higher precision is obtained.

(c) Overview of MAP decoding

(c-1) First feature of MAP decoding

With MAP decoding, the probabilities $\alpha_{0,k}(m)$, $\alpha_{1,k}(m)$ that decoded data $u_k$ is "0", "1" in each state (m = 0, 1, 2, 3) at time k (see Fig. 13) are decided based upon the following:

(1) probabilities $\alpha_{0,k-1}(m)$, $\alpha_{1,k-1}(m)$ in each state at time (k-1);
(2) the trellis (whether or not a path exists) between states at time (k-1) and time k; and
(3) receive data ya, yb at time k.

The probabilities $\alpha_{0,k-1}(m)$, $\alpha_{1,k-1}(m)$ in (1) above are referred to as "forward probabilities" ("forward metrics"). Further, the probability found by taking the trellis (2) and receive data (3) into account, namely the probability of a shift from state m' (= 0 to 3) at time (k-1) to state m (= 0 to 3) at time k is referred to as the "shift probability".

(c-2) Second feature of MAP decoding

With Viterbi decoding, the path of fewest errors leading to each state at a certain time k is obtained taking into account the receive data from 1 to k and the possible paths from 1 to k. However, the receive data from k to N and the paths from k to N are not at all reflected in the decision regarding paths of fewest errors. Unlike Viterbi decoding, MAP decoding is such that receive data from k to N and paths from k to N are reflected in decoding processing to obtain decoded data of higher precision.

More specifically, the probability $\beta_k(m)$ that a path of fewest errors will pass through each state m (= 0 to 3) at time k is found taking into consideration the receive data and trellises from N to k. Then, by multiplying the probability $\beta_k(m)$ by the forward probabilities $\alpha_{0,k}(m)$, $\alpha_{1,k}(m)$ of the corresponding state, a more precise probability that the decoded data $u_k$ in each state m (m = 0, 1, 2, 3) at time k will become "0", "1" is obtained.

To this end, the probability $\beta_k(m)$ in each state m (m = 0, 1, 2, 3) at time k is decided based upon the following:

(1) the probability $\beta_{k+1}(m)$ in each state at time (k+1);
(2) the trellis between states at time (k+1) and time k; and
(3) receive data ya, yb at time (k+1).

The probability $\beta_k(m)$ in (1) above is referred to as "backward probability" ("backward metric"). Further, the probability found by taking the trellis (2) and receive data (3) into account, namely the probability of a shift from state m' (= 0 to 3) at time (k+1) to state m (= 0 to 3) at time k is the shift probability.

Thus, the MAP decoding method is as follows, as illustrated in Fig. 13:

(1) Letting N represent information length, the forward probabilities $\alpha_{0,k}(m)$, $\alpha_{1,k}(m)$ of each state (m = 0 to 3) at time k are calculated taking into consideration the encoded data of 1 to k and trellises of 1 to k. That is, the forward probabilities $\alpha_{0,k}(m)$, $\alpha_{1,k}(m)$ of each state are found from the probabilities $\alpha_{0,k-1}(m)$, $\alpha_{1,k-1}(m)$ and shift probability of each state at time (k-1).
(2) Further, the backward probability $\beta_k(m)$ of each state (m = 0 to 3) at time k is calculated using the receive data of N to k and the paths of N to k. That is, the backward probability $\beta_k(m)$ of each state is calculated using the backward probability $\beta_{k+1}(m)$ and shift probability of each state at time (k+1).
(3) Next, the forward probabilities and backward probability of each state at time k are multiplied to obtain the joint probabilities as follows:

$$\lambda_{0,k}(m) = \alpha_{0,k}(m) \cdot \beta_k(m),$$

$$\lambda_{1,k}(m) = \alpha_{1,k}(m) \cdot \beta_k(m)$$

(4) This is followed by finding the sum total $\Sigma_m \lambda_{0,k}(m)$ of the probabilities of "1" and the sum total $\Sigma_m \lambda_{1,k}(m)$ of the probabilities of "0" in each state, calculating the probability that the original data $u_k$ of the kth item of data is "1" and that the probability is "0" based upon the magnitudes of the sum totals, outputting the larger probability as the kth item of decoded data and outputting the likelihood. The decoded result is a soft-decision output.

(d) First MAP decoding method according to prior art

(d-1) Overall structure of MAP decoder

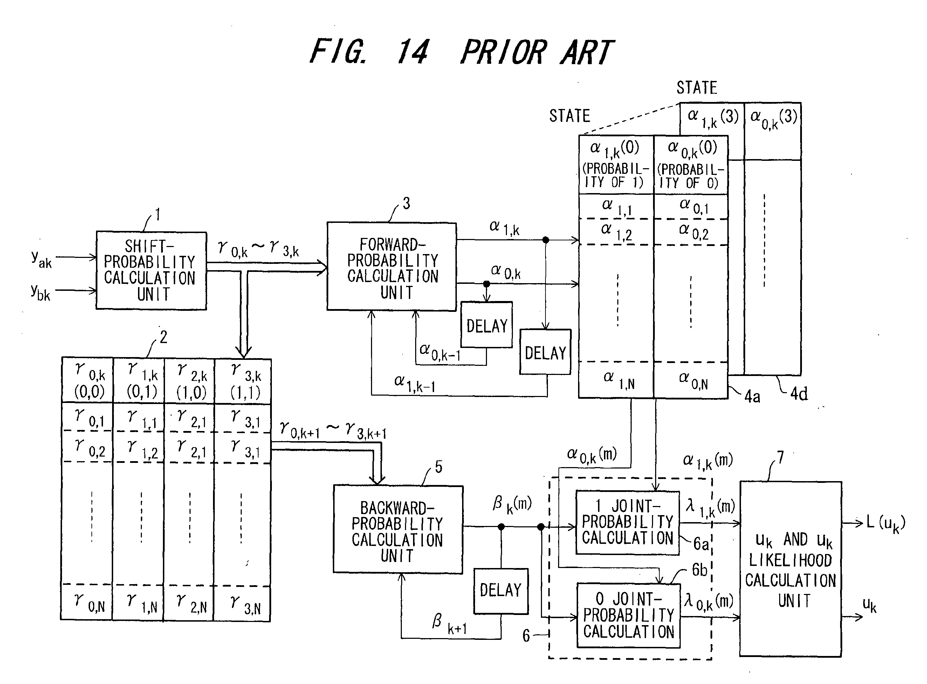

Fig. 14 is a block diagram of a MAP decoder for implementing a first MAP decoding method according to the prior art. (For example, see the specification of Japanese Patent No. 3,451,246.) Encoding rate R, information length N, original information u, encoded da-

ta $x_a$, $x_b$ and receive data $y_a$, $y_b$ are as follows:

- encoding rate: R = 1/2
- information length: N
- original information: u = {$u_1$, $u_2$, $u_3$, ···, $u_N$)
- encoded data: $x_a$ = {$x_{a1}$,$x_{a2}$,$x_{a3}$,···,$x_{ak}$,···,$x_{aN}$}
  : $x_b$ = {$x_{b1}$,$x_{b2}$,$x_{b3}$,···,$x_{bk}$,···,$x_{bN}$}
- receive data: $y_a$ = {$y_{a1}$,$y_{a2}$,$y_{a3}$,···,$y_{ak}$,···,$y_{aN}$}
  : $y_b$ = {$y_{b1}$,$y_{b2}$,$y_{b3}$,···,$y_{bk}$,···,$y_{bN}$}

That is, encoded data $x_a$, $x_b$ is generated from the original information u of information length N, an error is inserted into (occurs in) the encoded data at the time of reception, data $y_a$, $y_b$ is received and the original information u is decoded from the receive data.

Upon receiving ($y_{ak}$,$y_{bk}$) at time k, the shift-probability calculation unit 1 calculates the following probabilities and stores them in a memory 2:

probability $\gamma_{0,k}$ that ($x_{ak}$,$x_{bk}$) is (0,0)
probability $\gamma_{1,k}$ that ($x_{ak}$,$x_{bk}$) is (0,1)
probability $\gamma_{2,k}$ that ($x_{ak}$,$x_{bk}$) is (1,0)
probability $\gamma_{3,k}$ that ($x_{ak}$,$x_{bk}$) is (1,1)

Using the forward probability $\alpha_{1,k-1}(m)$ that the original data $u_{k-1}$ is "1" and the forward probability $\alpha_{0,k-1}(m)$ that the original data $u_{k-1}$ is "0" in each state m (= 0 to 3) at the immediately preceding time (k-1), as well as the obtained shift probabilities $\gamma_{0,k}$, $\gamma_{1,k}$, $\gamma_{2,k}$, $\gamma_{3,k}$ at time k, a forward-probability calculation unit 3 calculates the forward probability $\alpha_{1,k}(m)$ that the original data $u_k$ is "1" and the forward probability $\alpha_{0,k}(m)$ that the original data $u_k$ is "0" at time k and stores these probabilities in memories 4a to 4d. It should be noted that since processing always starts from state m=0, the initial values of forward probabilities are $\alpha_{0,0}(0) = \alpha_{1,0}(0) = 1$, $\alpha_{0,0}(m) = \alpha_{1,0}(m) = 0$ (where m≠0).

The shift-probability calculation unit 1 and forward-probability calculation unit 3 repeat the above-described calculations at k = k+1, perform the calculations from k=1 to k=N to calculate the shift probabilities $\gamma_{0,k}$, $\gamma_{1,k}$, $\gamma_{2,k}$, $\gamma_{3,k}$ and forward probabilities $\alpha_{1,k}(m)$, $\alpha_{0,k}(m)$ at each of the times k = 1 to N and store these probabilities in memory 2 and memories 4a to 4d, respectively.

Thereafter, a backward-probability calculation unit 5 calculates the backward probability $\beta_k(m)$ (m = 0 to 3) in each state m (= 0 to 3) at time k using the backward probability $\beta_{k+1}(m)$ and shift probability $\gamma_{s,k+1}$ (s = 0, 1, 2, 3) at time (k+1), where it is assumed that the initial value of k is N-1, that the trellis end state is m=0 and that $\beta_N(0) = 1$, $\beta_N(1) = \beta_N(2) = \beta_N(3) = 0$ hold.

A first arithmetic unit 6a in a joint-probability calculation unit 6 multiplies the forward probability $\alpha_{1,k}(m)$ and backward probability $\beta_k(m)$ in each state m (= 0 to 3) at time k to calculate the probability $\lambda_{1,k}(m)$ that the kth item of original data $u_k$ is "1", and a second arithmetic unit 6b in the joint-probability calculation unit 6 uses the forward probability $\alpha_{0,k}(m)$ and backward proba-

bility $\beta_k(m)$ in each state m (= 0 to 3) at time k to calculate the probability $\lambda_{0,k}(m)$ that the kth item of original data $u_k$ is "0".

A $u_k$ and $u_k$ likelihood calculation unit 7 adds the "1" probabilities $\lambda_{1,k}(m)$ (m = 0 to 3) in each of the states m (= 0 to 3) at time k, adds the "0" probabilities $\lambda_{0,k}(m)$ (m = 0 to 3) in each of the states m (= 0 to 3), decides the "1", "0" of the kth item of data $u_k$ based upon the results of addition, namely the magnitudes of $\Sigma_m\lambda_{1,k}(m)$ and $\Sigma_m\lambda_{0,k}(m)$, calculates the confidence (likelihood) $L(u_k)$ thereof and outputs the same.

The backward-probability calculation unit 5, joint-probability calculation unit 6 and $u_k$ and $u_k$ likelihood calculation unit 7 subsequently repeat the foregoing calculations at k = k+1, perform the calculations from k=N to k=1 to decide the "1", "0" of the original data $u_k$ at each of the times k = 1 to N, calculate the confidence (likelihood) $L(u_k)$ thereof and output the same.

(d-2) Calculation of forward probabilities

The forward probability $\alpha_k^i(m)$ that the decoded data $u_k$ will be i ("0" or "1") in each state (m = 0, 1, 2, 3) at time k is obtained in accordance with the following equation based upon

(1) forward probability $\alpha_{k-1}^i(m)$ in each state at time (k-1) and
(2) transition probability $\gamma_i(R_k,m',m)$ of a transition from state m' (= 0 to 3) at time (k-1) to state m (= 0 to 3) at time k:

$$\alpha_k^i(m) = \Sigma_{m'}\Sigma_j\gamma_i(R_k,m',m) \cdot \alpha_{k-1}^i(m')/$$

$$\Sigma_m\Sigma_{m'}\Sigma_i\Sigma_j\gamma_i(R_k,m',m) \cdot \alpha_{k-1}^i(m') \quad (1)$$

Here the transition probability $\gamma_i(R_k,m',m)$ is found based upon the trellis between state m' (= 0 to 3) at time (k-1) and the state m (= 0 to 3) at time k as well as the receive data $y_a$, $y_b$ at time k. Since the denominator in the above equation is a portion eliminated by division in the calculation of $u_k$ and likelihood of $u_k$, it need not be calculated.

(d-3) Calculation of backward probability

In each state (m = 0, 1, 2, 3) at time k, the backward probability $\beta_k(m)$ of each state is obtained in accordance with the following equation based upon

(1) backward probability $\beta_{k+1}(m)$ in each state at time (k+1) and
(2) transition probability $\gamma_i(R_{k+1},m',m)$ of a transition from state m (= 0 to 3) at time k to state m' (= 0 to 3) at time (k+1):

$$\beta_k(m) = \Sigma_{m'}\Sigma_i\gamma_i(R_{k+1},m,m') \cdot \beta_{k+1}(m')/$$

$$\Sigma_m \Sigma_{m'} , \Sigma_i \Sigma_j \gamma_i(R_k, m, m') \cdot \alpha^i_k(m) \qquad (2)$$

Here the transition probability $\gamma_i(R_{k+1}, m, m')$ is found based upon the trellis between state m (= 0 to 3) at time k and the state m' (= 0 to 3) at time (k+1) as well as the receive data $y_a$, $y_b$ at time (k+1). Since the denominator in the above equation is a portion eliminated by division in the calculation of likelihood, it need not be calculated.

(d-4) Calculation of joint probabilities and likelihood

If the forward probabilities $\alpha_{0,k}(m)$, $\alpha_{1,k}(m)$ and backward probability $\beta_k(m)$ of each state at time k are found, these are multiplied to calculate the joint probabilities as follows:

$$\lambda^0_k(m) = \alpha^0_k(m) \cdot \beta_k(m)$$

$$\lambda^1_k(m) = \alpha^1_k(m) \cdot \beta_k(m)$$

The sum total $\Sigma_m \lambda^0_k(m)$ of the probabilities of "0" and the sum total $\Sigma_m \lambda^1_k(m)$ of the probabilities of "1" in each of the states are then obtained and the likelihood is output in accordance with the following equation:

$$L(u) = \log[\Sigma_m \lambda^1_k(m) / \Sigma_m \lambda^0_k(m)] \qquad (3)$$

Further, the decoded result $u_k = 1$ is output if $L(u) > 0$ holds and the decoded result $u_k = 0$ is output if $L(u) < 0$ holds. That is, the probability that the kth item of original data $u_k$ is "1" and the probability that it is "0" are calculated based upon the magnitudes of the sum total $\Sigma_m \lambda^0_k(m)$ of the probabilities of "0" and of the sum total $\Sigma_m \lambda^1_k(m)$ of the probabilities of "1", and the larger probability is output as the kth item of decoded data.

(d-5) Problem with first MAP decoding method

The problem with the first MAP decoding method of the prior art shown in Fig. 14 is that the memory used is very large. Specifically, the first MAP decoding method requires a memory of $4 \times N$ (bits) for storing transition probabilities and a memory of m (number of states) $\times 2 \times N$ for storing forward probabilities, for a total memory of $(4 + m \times 2) \times N$. Since actual calculation is accompanied by soft-decision signals, additional memory which is eight times this figure is required.

(e) Second MAP decoding method according to prior art

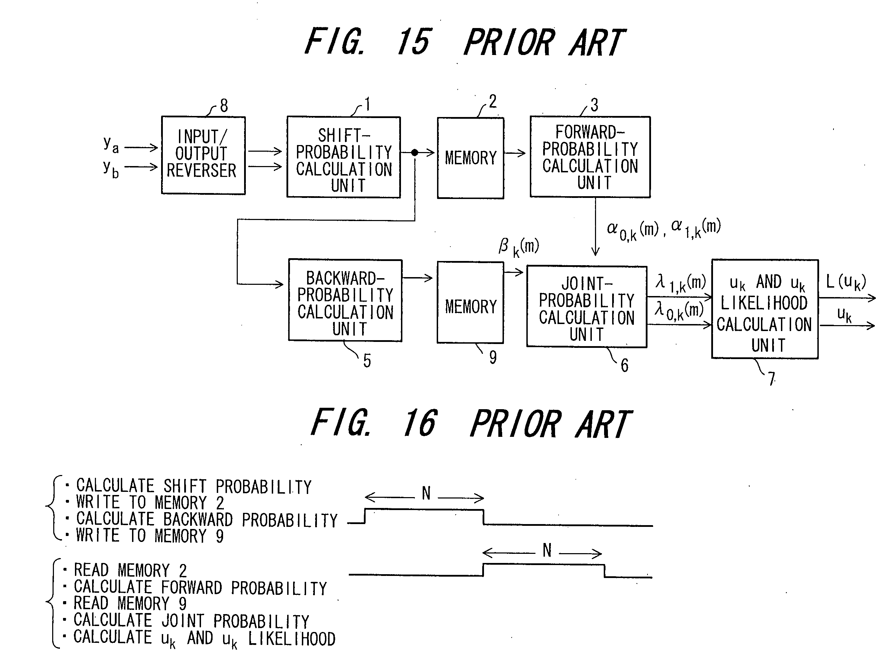

Accordingly, in order to reduce memory, a method that has been proposed is to perform the calculations upon switching the order in which the forward probability and backward probability are calculated. Fig. 15 is a block diagram of a MAP decoder for implementing this second MAP decoding method. Components identical with those shown in Fig. 14 are designated by like reference characters. An input/output reverser 8, which suitably reverses the order in which receive data is output, has a memory for storing all receive data and a data output unit for outputting the receive data in an order that is the reverse of or the same as that in which the data was input. With a turbo decoder that adopts the MAP decoding method as its decoding method, it is necessary to interleave the receive data and therefore memory for storing all receive data exists. This means that this memory for interleaving can also be used as the memory of the input/output reverser 8. Hence there is no burden associated with memory.

The shift-probability calculation unit 1 uses receive data $(y_{ak}, y_{bk})$ at time k (= N), calculates the following probabilities and stores them in the memory 2:

probability $\gamma_{0,k}$ that $(x_{ak}, x_{bk})$ is (0,0)

probability $\gamma_{1,k}$ that $(x_{ak}, x_{bk})$ is (0,1)

probability $\gamma_{2,k}$ that $(x_{ak}, x_{bk})$ is (1,0)

probability $\gamma_{3,k}$ that $(x_{ak}, x_{bk})$ is (1,1)

The backward-probability calculation unit 5 calculates the backward probability $\beta_{k-1}(m)$ (m = 0 to 3) in each state m (= 0 to 3) at time k-1 using the backward probability $\beta_k(m)$ and shift probability $\gamma_{s,k}$ (s = 0, 1, 2, 3) at time k (= N) and stores the backward probabilities in memory 9.

The shift-probability calculation unit 1 and backward-probability calculation unit 5 subsequently repeat the above-described calculations at k = k-1, perform the calculations from k=N to k=1 to calculate the shift probabilities $\gamma_{0,k}$, $\gamma_{1,k}$, $\gamma_{2,k}$, $\gamma_{3,k}$ and backward probability $\beta_k(m)$ at each of the times k = 1 to N and store these probabilities in memories 2, 9.

Thereafter, using the forward probability $\alpha_{1,k-1}(m)$ that the original data $u_{k-1}$ is "1" and the forward probability $\alpha_{0,k-1}(m)$ that the original data $u_{k-1}$ is "0" at time (k-1), as well as the obtained shift probabilities $\gamma_{0,k}$, $\gamma_{1,k}$, $\gamma_{2,k}$, $\gamma_{3,k}$ at time k, the forward-probability calculation unit 3 calculates the forward probability $\alpha_{1,k}(m)$ that $u_k$ is "1" and the forward probability $\alpha_{0,k}(m)$ that $u_k$ is "0" in each state m (= 0 to 3) at time k. It should be noted that the initial value of k is 1.

The joint-probability calculation unit 6 multiplies the forward probability $\alpha_{1,k}(m)$ and backward probability $\beta_k(m)$ in each state 0 to 3 at time k to calculate the probability $\lambda_{1,k}(m)$ that the kth item of original data $u_k$ is "1", and similarly uses the forward probability $\alpha_{0,k}(m)$ and backward probability $\beta_k(m)$ in each state 0 to 3 at time k to calculate the probability $\lambda_{0,k}(m)$ that the original data $u_k$ is "0".

The $u_k$ and $u_k$ likelihood calculation unit 7 adds the "1" probabilities $\lambda_{1,k}(m)$ (m = 0 to 3) of each of the states 0 to 3 at time k, adds the "0" probabilities $\lambda_{0,k}(m)$ (m = 0 to 3) of each of the states 0 to 3 at time k, decides the "1", "0" of the kth item of data $u_k$ based upon the results of addition, namely the magnitudes of $\Sigma_m \alpha_{1,k}(m)$ and $\Sigma_m \alpha_{0,k}(m)$, calculates the confidence (likelihood) L $(u_k)$ thereof and outputs the same.

The forward-probability calculation unit 3, joint-probability calculation unit 6 and $u_k$ and $u_k$ likelihood calculation unit 7 subsequently repeat the foregoing calculations at k = k+1, perform the calculations from k=1 to k=N to decide the "1", "0" of $u_k$ at each of the times k = 1 to N, calculate the confidence (likelihood) L $(u_k)$ thereof and output the same.

In accordance with the second MAP decoding method, as shown in the time chart of Fig. 16, the processing for calculation of shift probability, for calculation of backward probability and for storing the results of calculation in memory is executed in the first half, and the processing for calculating forward probability, for calculation of joint probability and for computation of original data and likelihood is executed in the second half. In other words, with the second MAP decoding method, forward probabilities $\alpha_{1,k}(m)$, $\alpha_{0,k}(m)$ are not stored but the backward probability $\beta_k(m)$ is stored. As a result, memory required for the second MAP decoding method is just 4 $\times$ N for storing shift probability and m $\times$ N (where m is the number of states) for storing backward probability, so that the total amount of memory required is (4+m) $\times$ N. Thus the amount of memory required can be reduced in comparison with the first MAP decoding method of Fig. 14.

It should be noted that the memory 2 for storing shift probability is not necessarily required. It can be so arranged that forward probabilities $\alpha_{1,k}(m)$, $\alpha_{0,k}(m)$ can be calculated by calculating the shift probabilities $\gamma_{0,k}$ (s = 0, 1, 2, 3) on each occasion.

(f) Third MAP decoding method according to prior art

With the second MAP decoding method, the backward probability $\beta_k(m)$ need only be stored and therefore the amount of memory is comparatively small. However, it is necessary to calculate all backward probabilities $\beta_k(m)$. If we let N represent the number of data items and Tn the time necessary for processing one node, then the decoding time required will be 2 $\times$ Tn $\times$ N. This represents a problem.

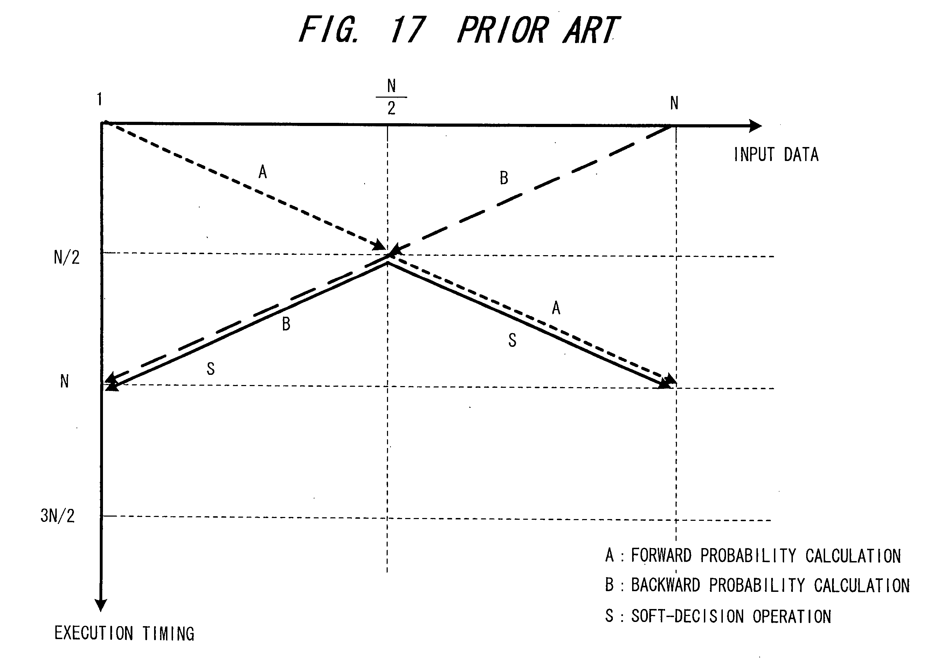

Fig. 17 is a diagram useful in describing a third MAP decoding method according to the prior art. Data 1 to N is plotted along the horizontal axis and execution time along the vertical axis. Further, A indicates forward probability or calculation thereof, B indicates backward probability or calculation thereof, and S indicates a soft-decision operation (joint probability, $u_k$ and $u_k$ likelihood calculation).

According to this method, the results of the backward probability calculation B are stored in memory while the calculation is performed from N-1 to N/2. Similarly, the results of the forward probability calculation A are stored in memory while the calculation is performed from 0 to N/2. If we let Tn represent the time necessary for the processing of one node, a time of Tn $\times$ N/2 is required for all processing to be completed. Thereafter, with regard to N/2 to 0, forward probability A has already been calculated and therefore likelihood is calculated while backward probability B is calculated. With regard to N/2 to N-1, backward probability B has been calculated and therefore likelihood is calculated while forward probability A is calculated. Calculations are performed by executing these processing operations concurrently. As a result, processing is completed in the next period of time of

Tn $\times$ N/2. That is, according to the third MAP decoding method, decoding can be performed in time Tn $\times$ N and decoding time can be shorted in comparison with the second MAP decoding method. However, since forward probability must be stored, a greater amount of memory is used in comparison with the second MAP decoding method.

(g) Fourth MAP decoding method according to prior art

The second and third methods cannot solve both the problem relating to decoding time and the problem relating to amount of memory used. Accordingly, a metric calculation algorithm for shortening decoding time and reducing amount of memory used has been proposed. The best-known approach is referred to as the "sliding window method" (referred to as the "SW method" below), the actual method proposed by Viterbi. (For example, see IEEE JOURNAL ON SELECTED AREAS IN COMMUNICATIONS, VOL. 16, NO. 2, FEBRUARY 1998, "An Intuitive Justification and a Simplified Implementation of the MAP Decoder for Convolutional Codes", Andrew J. Viterbi.)

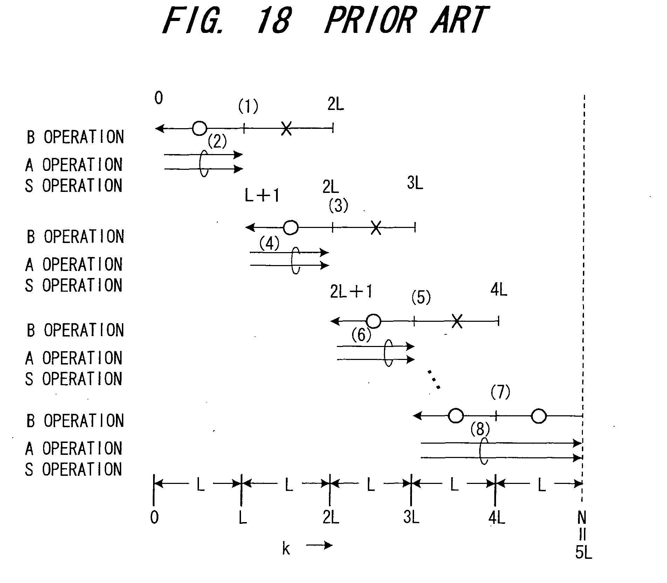

Fig. 18 is a diagram useful in describing the operation sequence of a fourth MAP decoding method using the SW method according to the prior art. Here a B operation signifies backward probability calculation (inclusive of shift probability calculation), an A operation signifies forward probability calculation (inclusive of shift probability calculation), and an S operation signifies soft-decision calculation (joint probability calculation / likelihood calculation).

In the SW method, k = 1 to N is divided equally into intervals L and MAP decoding is executed as set forth below.

First, (1) the B operation is performed from k = 2L to k = 1. In the B operation, the backward probability $\beta_k(m)$ is not calculated from k = N; calculation starts from the intermediate position k = 2L. As a consequence, the backward probability $\beta_k(m)$ found over k = 2L to k = L+1 (a training period) in the first half cannot be trusted and is discarded. The backward probability $\beta_k(m)$ found over

k = L to k = 1 in the second half can be trusted to some extent and therefore this is stored in memory. (2) Next, the A operation is performed at k = 1, the S operation is performed using the results $\alpha_{1,1}(m)$, $\alpha_{0,1}(m)$ of the A operation at k = 1 as well as $\beta_1(m)$ that has been stored in memory, and the decoded result $u_1$ and likelihood $L(u_1)$ are calculated based upon the joint probabilities. Thereafter, and in similar fashion, the A operation is performed from k = 2 to k = L and the S operation is performed based upon the results of the A operation and the results of the B operation in memory. This ends the calculation of the decoded result $u_k$ and likelihood $L(u_k)$ from k = 1 to k = L.

Next, (3) the B operation is performed from k = 3L to k = L+1. In the B operation, the backward probability $\beta_k(m)$ is not calculated from k = N; calculation starts from the intermediate position k = 3L. As a consequence, the backward probability $\beta_k(m)$ found over k = 3L to k = 2L+1 (the training period) in the first half cannot be trusted and is discarded. The backward probability $\beta_k(m)$ found over k = 2L to k = L+1 in the second half can be trusted to some extent and therefore this is stored in memory. (4) Next, the A operation is performed at k = L+1, the S operation is performed using the results $\alpha_{1,L+1}(m)$, $\alpha_{0,L+1}(m)$ of the A operation at k = L+1 as well as $\beta_{L+1}(m)$ that has been stored in memory, and the decoded result $u_{L+1}$ and likelihood $L(u_{L+i})$ are calculated based upon the joint probabilities. Thereafter, and in similar fashion, the A operation is performed from k = L+2 to k = 2L and the S operation is performed based upon the results of the A operation and the results of the B operation in memory. This ends the calculation of the decoded result $u_k$ and likelihood $L(u_k)$ from k = L+1 to k = 2L. Thereafter, and in similar fashion, the calculation of the decoded result $u_k$ and likelihood $L(u_k)$ up to k = N is performed.

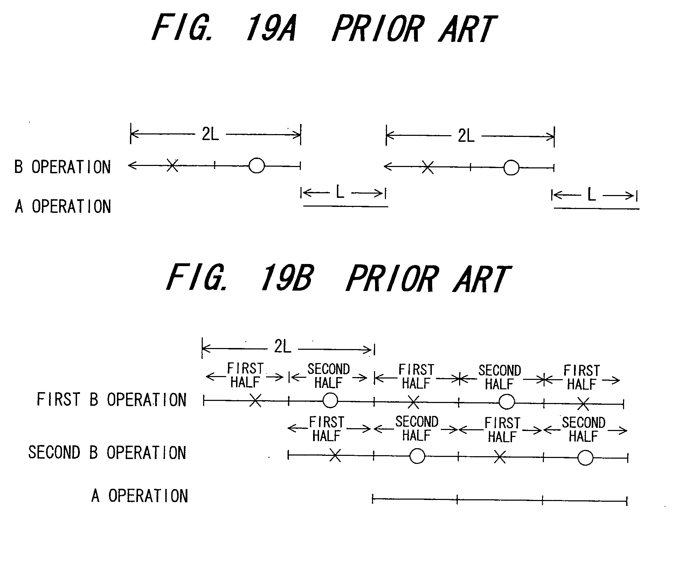

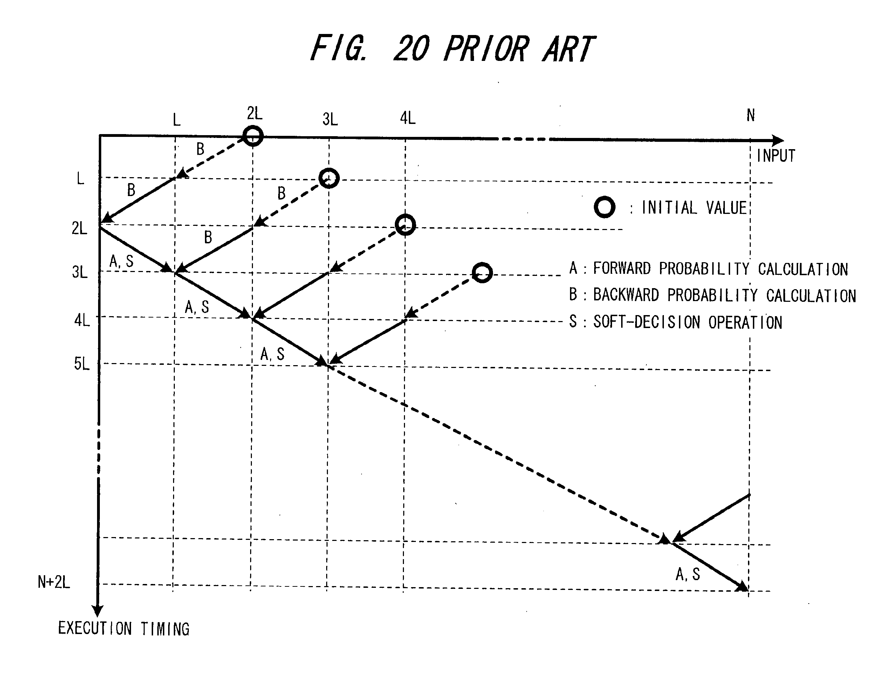

It should be noted that in the third MAP decoding method set forth above, the A operation over L is performed after the B operation over 2L. In terms of a time chart, therefore, this is as indicated in Fig. 19A. Here, however, the A operation is intermittent and calculation takes time as a result. Accordingly, by so arranging it that the A operation is performed continuously by executing the first and second halves of the B operation simultaneously using two means for calculating backward probability, as shown in Fig. 19B, the speed of computation can be raised. Fig. 20 is a time chart having an expression format the same as that of the present invention described later and illustrates content identical with that of Fig. 19B. The horizontal and vertical axes indicate input data and processing time, respectively.

In accordance with MAP decoding in the SW method, one forward probability calculation unit, two backward probability calculation units and one soft-decision calculation unit are provided and these are operated in parallel, whereby one block's worth of a soft-decision processing loop can be completed in a length of time of (N+2L) x Tn. Further, the amount of memory necessary is merely that equivalent to 2L nodes of backward probability.

With the SW method, backward probability $\beta_k(m)$ is not calculated starting from k = N. Since the same initial value is set and calculation starts in mid-course, the backward probability $\beta_k(m)$ is not accurate. In order to obtain a good characteristic in the SW method, therefore, it is necessary to provide a satisfactory training period $T_L$. The length of this training portion ordinarily is required to be four to five times the constraint length.

If the encoding rate is raised by puncturing, punctured bits in the training portion can no longer be used in calculation of metrics. Consequently, even a training length that is four to five times the constraint length will no longer be satisfactory and a degraded characteristic will result. In order to maintain a good characteristic, it is necessary to increase the length of the training portion further. A problem which arises is an increase in amount of computation needed for decoding and an increase in amount of memory used.

Accordingly, it is therefore desirable to enable a reduction in memory used and, moreover, to substantially lengthen the training portion so that backward probability $\beta_k(m)$ can be calculated accurately and the precision of MAP decoding improved.

According to the present invention, there is provided a maximum a posteriori probability decoding method (MAP decoding method) and apparatus for repeatedly executing decoding processing using the sliding window (SW) method. The sliding window (SW) method includes dividing encoded data of length N into blocks each of prescribed length L, calculating backward probability from a data position (initial positions) backward of a block of interest when the backward probability of the block of interest is calculated, obtaining and storing the backward probability of the block of interest, then calculating forward probability, executing decoding processing of each data item of the block of interest using the forward probability and the stored backward probability and subsequently executing decoding processing of each block in regular order.

In maximum a posteriori probability decoding for repeatedly executing decoding processing using the sliding window (SW) method, the fundamental principle of the present invention is as follows: Forward probabilities and/or backward probabilities at initial positions, which probabilities have been calculated during a current cycle of MAP decoding processing, are stored as initial values of forward probabilities and/or backward probabilities in MAP decoding executed in the next cycle. Then, in the next cycle of MAP decoding processing, calculation of forward probabilities and/or backward probabilities is started from the stored initial values.

In first maximum a posteriori probability decoding, backward probability at a starting point (initial position) of backward probability calculation of another block, which backward probability is obtained in current decoding processing of each block, is stored as an initial value of backward probability of the other block in decoding processing to be executed next, and calculation of backward probability of each block is started from the stored initial value in decoding processing the next time.

In second maximum a posteriori probability decoding, backward probability at a starting point of another block, which backward probability is obtained in current decoding processing of each block, is stored as an initial value of backward probability of the other block in decoding processing to be executed next, and calculation of backward probability is started, without training, from the starting point of this block using the stored initial value in decoding processing of each block executed next.

In third maximum a posteriori probability decoding, (1) encoded data of length N is divided into blocks each of prescribed length L and processing for calculating backward probabilities from a data position (backward-probability initial position) backward of each block, obtaining the backward probabilities of this block and storing the backward probabilities is executed in parallel simultaneously for all blocks; (2) when forward probability of each block is calculated, processing for calculating forward probability from a data position (forward-probability initial position) ahead of this block and obtaining the forward probabilities of this block is executed in parallel simultaneously for all blocks; (3) decoding processing of the data in each block is executed in parallel simultaneously using the forward probabilities of each block and the stored backward probabilities of each block; (4) a backward probability at the backward-probability initial position of another block, which backward probability is obtained in current decoding processing of each block, is stored as an initial value of backward probability of the other block in decoding processing to be executed next; (5) a forward probability at the forward-probability initial position of another block, which forward probability is obtained in current decoding processing of each block, is stored as an initial value of forward probability of the other block in decoding processing to be executed next; and (6) calculation of forward probability and backward probability of each block is started in parallel using the stored initial values in decoding processing executed next.

By means of the present invention, a training period can be substantially secured (extended) and deterioration of the characteristic at a high encoding rate can be prevented even if the length of the training portion is short, e.g., even if the length of the training portion is made less than four to five times the constraint length or even if there is no training portion. Further, the amount of calculation performed by a turbo decoder and the amount of memory used can also be reduced.

First maximum a posteriori probability decoding according to the present invention is such that from the second execution of decoding processing onward, backward probabilities for which training has been completed are set as initial values. Though this results in slightly more memory being used in comparison with a case where the initial values are made zero, substantial training length is extended, backward probability can be calculated with excellent precision and deterioration of characteristics can be prevented.

Second maximum a posteriori probability decoding according to the present invention is such that from the second execution of decoding processing onward, backward probability for which training has been completed is set as the initial value. Though this results in slightly more memory being used in comparison with a case where the initial value is made zero, substantial training length is extended, backward probability can be calculated with excellent precision and deterioration of characteristics can be prevented. Further, the amount of calculation in the training portion can be reduced and time necessary for decoding processing can be shortened.

In accordance with third maximum a posteriori probability decoding according to the present invention, forward and backward probabilities are both calculated using training data in metric calculation of each sub-block, whereby all sub-blocks can be processed in parallel. This makes high-speed MAP decoding possible. Further, in the second execution of decoding processing onward, forward and backward probabilities calculated and stored one execution earlier are used as initial values in calculations of forward and backward probabilities, respectively, and therefore highly precise decoding processing can be executed.

Other features and advantages of the present invention will be apparent from the following description taken in conjunction with the accompanying drawings, in which:

> Fig. 1 is a block diagram illustrating the configuration of a communication system that includes a turbo encoder and a turbo decoder;
> Fig. 2 is a block diagram of the turbo decoder;
> Fig. 3 is a time chart of a maximum a posteriori probability decoding method according to a first embodiment of the present invention;
> Fig. 4 is a block diagram of a maximum a posteriori probability decoding apparatus according to the first embodiment;
> Fig. 5 is a time chart of a maximum a posteriori probability decoding method according to a second embodiment of the present invention;
> Fig. 6 is a time chart of a maximum a posteriori probability decoding method according to a third embodiment of the present invention;
> Fig. 7 is a block diagram of a maximum a posteriori probability decoding apparatus according to the third embodiment;
> Fig. 8 is a diagram useful in describing the sequence of turbo decoding to which the present invention can be applied;
> Fig. 9 shows an example of an encoder according to the prior art;

Fig. 10 is a diagram useful in describing the relationship between inputs and outputs of a convolutional encoder as well as the states of a shift register according to the prior art;

Fig. 11 is a diagram useful in describing the states of the convolutional encoder;

Fig. 12 is a diagram showing the relationship between the states and input/output of a convolutional encoder according to the prior art;

Fig. 13 is a trellis diagram in which convolutional codes of the convolutional encoder are expressed in the form of a lattice according to the prior art;

Fig. 14 is a block diagram of a MAP decoder for implementing a first MAP decoding method according to the prior art;

Fig. 15 is a block diagram of a MAP decoder for implementing a second MAP decoding method according to the prior art;

Fig. 16 is a time chart associated with Fig. 15;

Fig. 17 is a diagram useful in describing a third MAP decoding method according to the prior art;

Fig. 18 is a diagram useful in describing a calculation sequence for describing a fourth MAP decoding method using the SW method according to the prior art;

Figs. 19A and 19B are time charts of the fourth MAP decoding method according to the prior art; and

Fig. 20 is a time chart of the prior-art fourth MAP decoding method having an expression format identical with that of the present invention.

## (A) Turbo codes

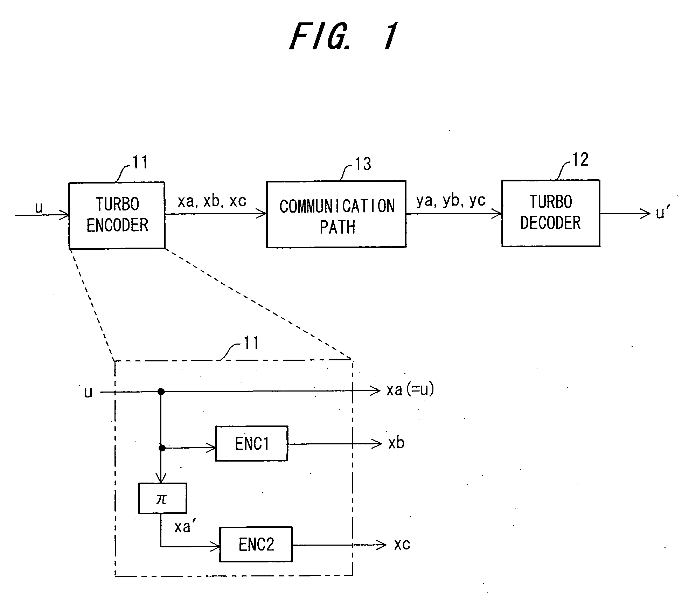

The MAP decoding method manifests its effectiveness in turbo codes. Fig. 1 is a block diagram of a communication system that includes a turbo encoder 11 and a turbo decoder 12. The turbo encoder 11 is provided on the data transmitting side and the turbo decoder 12 is provided on the data receiving side. Numeral 13 denotes a data communication path. Further, reference character u represents informational data to be transmitted of length N; xa, xb, xc represent encoded data obtained by encoding the informational data u by the turbo encoder 11; ya, yb,yc denote received (receive) signals that have been influenced by noise and fading as a result of propagation of the encoded data xa, xb, xc through the communication path 13; and u' represents results of decoding obtainedby decoding the received (receive) data ya, yb, yc by the turbo decoder 12. These items of data are as expressed below.

Original data: $u = \{u_1, u_2, u_3, \cdots, u_N\}$

Encoded data: $xa = \{x_{a1}, x_{a2}, x_{a3}, \cdots, x_{ak}, \cdots, x_{aN}\}$

　　: $xb = \{x_{b1}, x_{b2}, x_{b3}, \cdots, x_{bk}, \cdots, x_{bN}\}$

　　: $xc = \{x_{c1}, x_{c2}, x_{c3}, \cdots, x_{ck}, \cdots, x_{cN}\}$

Receive data: $ya = \{y_{a1}, y_{a2}, y_{a3}, \cdots, y_{ak}, \cdots, y_{aN}\}$

　　: $yb = \{y_{b1}, y_{b2}, y_{b3}, \cdots, y_{bk}, \cdots, y_{bN}\}$

　　: $yc = \{y_{c1}, y_{c2}, y_{c3}, \cdots, y_{ck}, \cdots, y_{cN}\}$

The turbo encoder 11 encodes the informational data u of information length N and outputs the encoded data xa, xb, xc. The encoded data xa is the informational data u per se, the encoded data xb is data obtained by the convolutional encoding of the informational data u by an encoder ENC1, and the encoded data xc is data obtained by the interleaving (π) and convolutional encoding of the informational data u by an encoder ENC2. In other words, a turbo code is obtained by combining two convolutional codes. It should be noted that an interleaved output xa' differs from the encoded data xa only in terms of its sequence and therefore is not output.

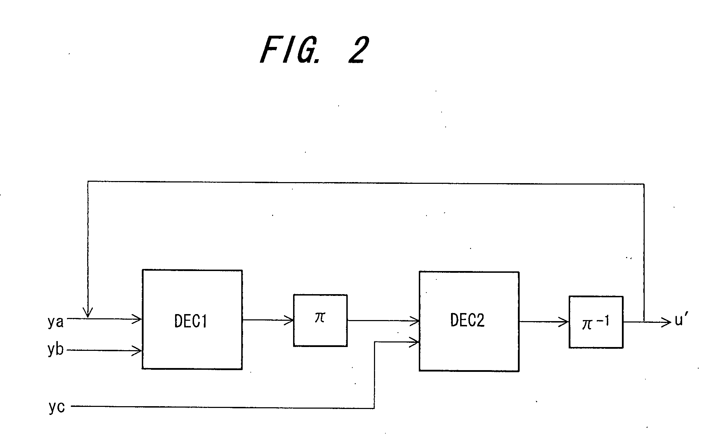

Fig. 2 is a block diagram of the turbo decoder. Turbo decoding is performed by a first element decoder DEC1 using ya and yb first among the receive signals ya, yb, yc. The element decoder DEC1 is a soft-output element decoder and outputs the likelihood of decoded results. Next, similar decoding is performed by a second element decoder DEC2 using the likelihood, which is output from the first element decoder DEC1, and yc. That is, the second element decoder DEC2 also is a soft-output element decoder and outputs the likelihood of decoded results. Here yc is a receive signal corresponding to xc, which was obtained by interleaving and then encoding the original data u. Accordingly, the likelihood that is output from the first element decoder DEC1 is interleaved (π) before it enters the second element decoder DEC2. The likelihood output from the second element decoder DEC2 is deinterleaved ($\pi^{-1}$) and then is fed back as the input to the first element decoder DEC1. Further, u' is decoded data (results of decoding) obtained by rendering a "0", "1" decision regarding the interleaved results from the second element decoder DEC2. Error rate is reduced by repeating the above-described decoding operation a prescribed number of times.

MAP element decoders can be used as the first and second element decoders DEC1, DEC2 in such a turbo element decoder.

## (B) First Embodiment

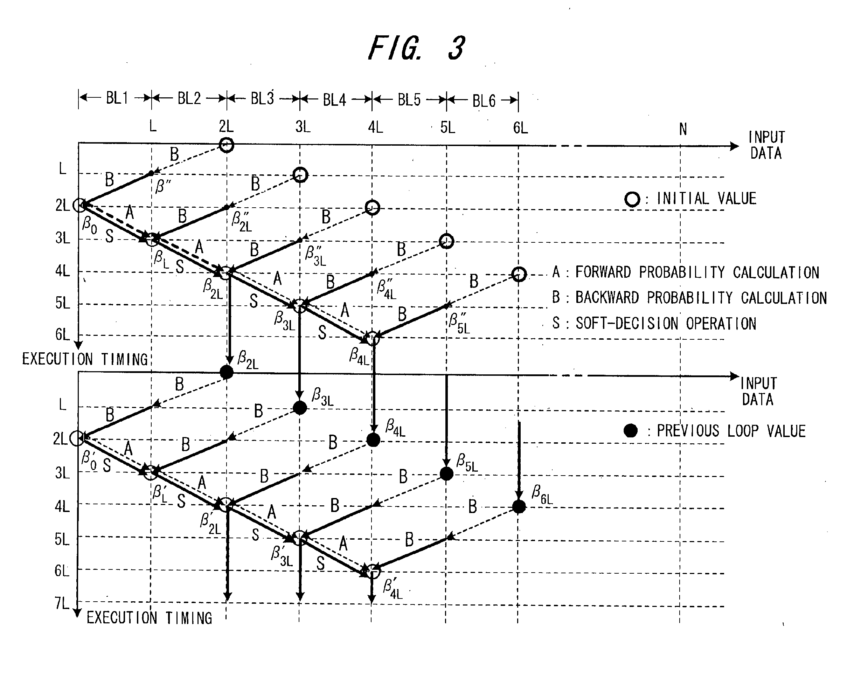

Fig. 3 is a time chart of a maximum a posteriori probability decoding method according to a first embodiment applicable to a MAP element decoder.

According to the first embodiment, processing identical with that of the conventional SW method is performed in the first execution of decoding processing (the upper half of Fig. 3). Specifically, backward probabilities in respective ones of blocks, namely a block BL1 from L to 0, a block BL2 from 2L to L, a block BL3 from 3L to 2L, a block BL4 from 4L to 3L, a block BL5 from 5L to 4L, ⋯, are calculated in order from data positions (initial positions) backward of each block using prescribed values as initial values, whereby backward probabilities at the starting points of each of the blocks are obtained. (This represents backward-probability training.) For example, backward probabilities are trained (calculated) in order from data positions 2L, 3L, 4L, 5L, 6L, ··· backward of each of the blocks to obtain backward probabilities at starting points L, 2L, 3L, 4L, 5L, ··· of each of the blocks. After such training is performed, the backward probabilities of each of the blocks BL1, BL2, BL3, ··· are calculated from the backward probabilities of the starting points of the blocks, and the calculated backward probabilities are stored. After the calculation of all backward probabilities, forward probabilities are calculated and processing for decoding each data item in a block of interest is executed using the forward probability and the stored backward probability. It should be noted that processing for decoding each of the blocks is executed in the following order, as should be obvious from the time chart: first block, second block, third block, ··· and so on.

In the first execution of decoding processing (the upper half of Fig. 3) based upon the SW method, values of backward probabilities $\beta_0$, $\beta_L$, $\beta_{2L}$, $\beta_{3L}$, $\beta_{4L}$, ··· at final data positions 0, L, 2L, 3L, 4L, ··· of each of the blocks are stored as initial values of backward probabilities for the next time. (In actuality, $\beta_0$ and $\beta_L$ are not used.)

In the second execution of decoding processing (the lower half of Fig. 3), backward probabilities in respective ones of blocks, namely block BL1 from L to 0, block BL2 from 2L to L, block BL3 from 3L to 2L, block BL4 from 4L to 3L, block BL5 from 5L to 4L, ···, are calculated, after training, using the stored backward probabilities $\beta_{2L}$, $\beta_{3L}$, $\beta_{4L}$, ··· as initial values. It should be noted that in the second execution of decoding processing, values of backward probabilities $\beta_0'$, $\beta_L'$, $\beta_{2L}'$, $\beta_{3L}'$, $\beta_{4L}'$, ··· at final data positions 0, L, 2L, 3L, 4L, ··· in each of the blocks are stored as initial values of backward probabilities for the next time.

As set forth above, values of backward probabilities $\beta_0$, $\beta_L$, $\beta_{2L}$, $\beta_{3L}$, $\beta_{4L}$, ··· at final data positions 0, L, 2L, 3L, 4L, ··· of each of the blocks are stored as initial values of backward probabilities for the next time. However, values of backward probabilities $\beta_0''$, $\beta_L''$, $\beta_{2L}''$, $\beta_{3L}''$, $\beta_{4L}''$, ··· at intermediate positions can also be stored as initial values of backward probabilities for the next time.

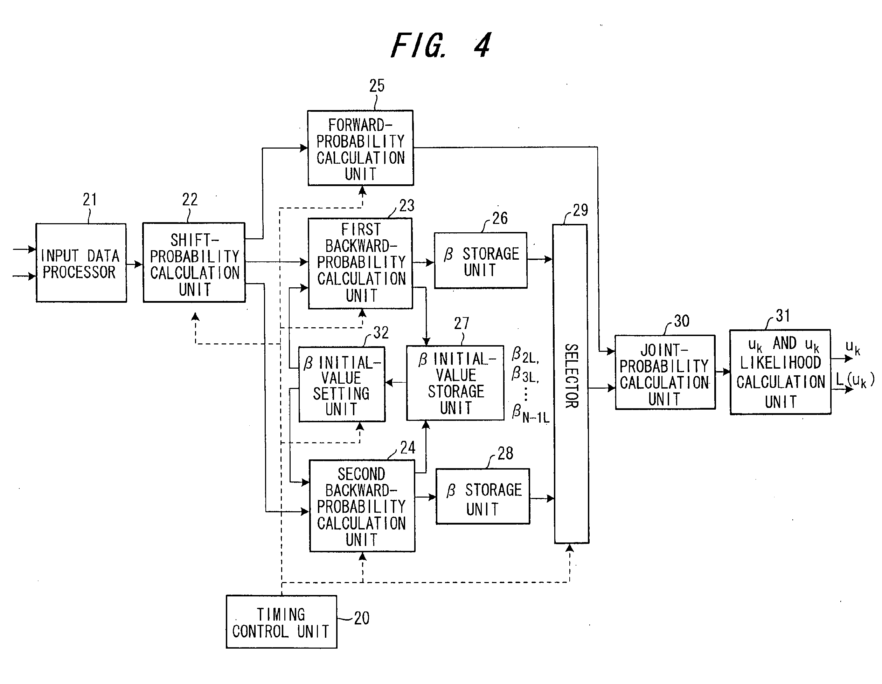

Fig. 4 is a block diagram of a maximum a posteriori probability decoding apparatus according to the first embodiment. Processing and calculations performed by the components of this apparatus are controlled by timing signals from a timing control unit 20.

An input data processor 21 extracts the necessary part of receive data that has been stored in a memory (not shown) and inputs this data to a shift-probability calculation unit 22. The latter calculates the shift probability of the input data and inputs the shift probability to first and second backward-probability calculation units 23, 24, respectively, and to a forward-probability calculation unit 25.

The first backward-probability calculation unit 23 starts the training calculation of backward probabilities in L to 0, 3L to 2L, 5L to 4L, ··· of the odd-numbered blocks BL1, BL3, BL5, ··· in Fig. 3 from the initial positions (2L, 4L, 6L, ···), stores the backward probabilities of these blocks in a β storage unit 26, calculates values of backward probabilities ($\beta_0$, $\beta_{2L}$, $\beta_{4L}$, ···) at final data positions (0, 2L, 4L, ···) of each of the blocks and stores these in a β initial-value storage unit 27 as initial values of backward probabilities for the next time. It should be noted that the final backward probability $\beta_{jL}$ of the (j+2)th block is used as the initial value of backward probability of the jth block in decoding processing the next time, where j is an odd number.

The second backward-probability calculation unit 24 starts the training calculation of backward probabilities in 2L to L, 4L to 3L, 6L to 5L, ··· of the even-numbered blocks BL2, BL4, BL6, ··· in Fig. 3 from the initial positions (3L, 5L, 7L, ···), stores the backward probabilities of these blocks in a β storage unit 28, calculates values of backward probabilities ($\beta_L$, $\beta_{3L}$, $\beta_{5L}$, ···) at final data positions (L, 3L, 5L, ···) of each of the blocks and stores these in the β initial-value storage unit 27 as initial values of backward probabilities for the next time. It should be noted that the final backward probability $\beta_{JL}$ of the (j+2)th block is used as the initial value of backward probability of the jth block in decoding processing the next time, where j is an odd number.

The forward-probability calculation unit 25 calculates the forward probabilities of each of the blocks continuously. A selector 29 appropriately selects and outputs backward probabilities that have been stored in the β storage units 26, 28, a joint-probability calculation unit 30 calculates the joint probability, and a $u_k$ and $u_k$ likelihood calculation unit 31 decides the "1", "0" of data $u_k$, calculates the confidence (likelihood) $L(u_k)$ thereof and outputs the same.

If a first execution of decoding processing of all 1 to N data items has been completed, then the β initial-value setting unit 32 reads the initial values of β out of the β initial-value storage unit 27 and sets these in the backward-probability calculation units 23, 24 when the first and second backward-probability calculation units 23, 24 calculate the backward probabilities of each of the blocks in the next execution of decoding processing.

Each of the above units executes decoding processing in order block by block at timings (Figs. 19 and 20) similar to those of the well-known SW method based upon timing signals from the timing control unit 20 in accordance with the time chart of Fig. 3.

Thus, the first embodiment is such that from the second execution of decoding processing onward, backward probabilities $\beta_0$, $\beta_L$, $\beta_{2L}$, $\beta_{3L}$, $\beta_{4L}$, ··· for which training has been completed are set as initial values. Though this results in slightly more memory being used in comparison with a case where fixed values are adopted as the initial values, substantial training length is extended threefold, backward probabilities can be calculated with excellent precision and deterioration of characteristics can be prevented.

(C) Second Embodiment

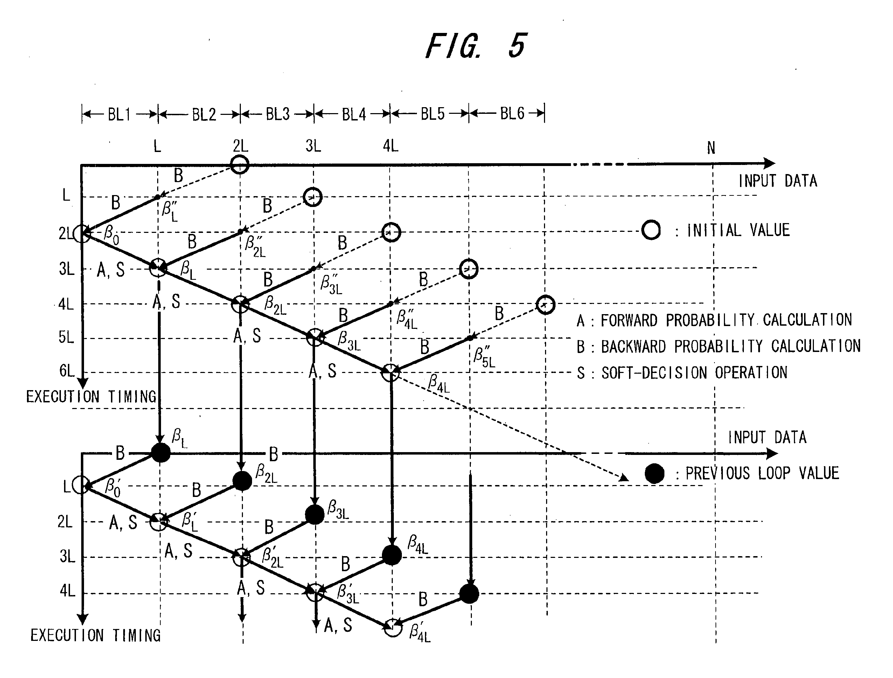

Fig. 5 is a time chart of a maximum a posteriori probability decoding method according to a second embodiment.

According to the second embodiment, processing identical with that of the conventional SW method is performed in the first execution of decoding processing (the upper half of Fig. 5). Specifically, backward probabilities in respective ones of blocks, namely block BL1 from L to 0, block BL2 from 2L to L, block BL3 from 3L to 2L, block BL4 from 4L to 3L, block BL5 from 5L to 4L, ⋯, are calculated in order from data positions (initial positions) backward of each block using fixed values an initial values, whereby backward probabilities at the starting points of each of the blocks are obtained. (This represents backward-probability training.) For example, backward probabilities are trained (calculated) in order from data positions 2L, 3L, 4L, 5L, 6L, ⋯ backward of each of the blocks to obtain backward probabilities at starting points L, 2L, 3L, 4L, 5L, ⋯ of each of the blocks. After such training is performed, the backward probabilities of each of the blocks BL1, BL2, BL3, ⋯ are calculated from the backward probabilities of the starting points of the blocks and the calculated backward probabilities are stored. After the calculation of all backward probabilities, forward probabilities are calculated and processing for decoding each data item in a block of interest is executed using forward probability and the stored backward probability. It should be noted that the decoding processing of each of the blocks is executed in order as follows, as should be obvious from the time chart: first block, second block, third block, ⋯, and so on.

In the first execution of decoding processing (the upper half of Fig. 5) based upon the SW method, values of backward probabilities $\beta_0$, $\beta_L$, $\beta_{2L}$, $\beta_{3L}$, $\beta_{4L}$, ⋯ at final data positions 0, L, 2L, 3L, 4L, ⋯ of each of the blocks are stored as initial values of backward probabilities for the next time. (In actuality, $\beta_0$ is not used.)

In the second execution of decoding processing (the lower half of Fig. 5), the backward probabilities in respective ones of the blocks, namely block BL1 from L to 0, block BL2 from 2L to L, block BL3 from 3L to 2L, block BL4 from 4L to 3L, block BL5 from 5L to 4L, ⋯, are calculated directly, without carrying out training, using the stored backward probabilities $\beta_L$, $\beta_{2L}$, $\beta_{3L}$, $\beta_{4L}$ ⋯ as initial values. Furthermore, in the second execution of decoding processing, values of backward probabilities $\beta_0'$, $\beta_L'$, $\beta_{2L}'$, $\beta_{3L}'$, $\beta_{4L}'$, ⋯ at final data positions 0, L, 2L, 3L, 4L, ⋯ in each of the blocks are stored as initial values of backward probabilities for the next time.

As set forth above, values of backward probabilities $\beta_0$, $\beta_L$, $\beta_{2L}$, $\beta_{3L}$, $\beta_{4L}$, ⋯ at final data positions 0, L, 2L, 3L, 4L, ⋯ of each of the blocks are stored as initial values of backward probabilities for the next time. However, values of backward probabilities $\beta_0''$, $\beta_L''$, $\beta_{2L}''$, $\beta_{3L}''$, $\beta_{4L}''$, ⋯ at intermediate positions can also be stored as initial values of backward probabilities for the next time.

A maximum a posteriori probability decoding apparatus according to the second embodiment has a structure identical with that of the first embodiment in Fig. 4. The apparatus executes decoding processing in order block by block at timings (Figs. 19 and 20) similar to those of the well-known SW method based upon timing signals from the timing control unit 20 in accordance with the time chart of Fig. 5.

Thus, the second embodiment is such that from the second execution of decoding processing onward, backward probabilities for which training has been completed are set as initial values. Though this results in slightly more memory being used in comparison with a case where fixed values are adopted as the initial values, substantial training length is extended, backward probabilities can be calculated with excellent precision and deterioration of characteristics can be prevented. In addition, the amount of calculation in the training portion can be reduced and time necessary for decoding processing can be shortened. Further, though the amount of calculation in the training portion can be reduced, the training length is twice that of the conventional SW method, backward probabilities can be calculated with excellent precision and deterioration of characteristics can be prevented.

(D) Third Embodiment

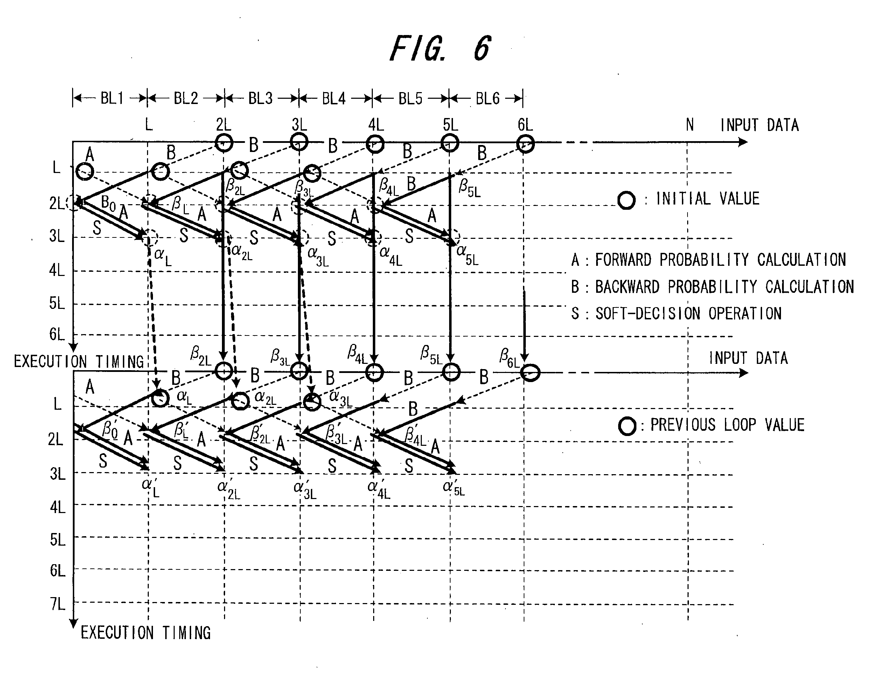

Fig. 6 is a time chart of a maximum a posteriori probability decoding method according to a third embodiment.

The third embodiment is premised on the fact that all input receive data of one encoded block has been read in and stored in memory. Further, it is assumed that backward-probability calculation means, forward probability-calculation means and soft-decision calculation means have been provided for each of the blocks of block BL1 from L to 0, block BL2 from 2L to L, block BL3 from 3L to 2L, block BL4 from 4L to 3L, block BL5 from 5L to 4L, ⋯. The third embodiment features the following four points: (1) SW-type decoding processing is executed in parallel block by block; (2) forward-probability calculation means for each block executes a training operation and calculates forward probability; (3) forward probabilities and backward probabilities obtained in the course of the preceding calculations are stored as initial values for calculations the next time; and (4) calculations are performed the next time using the stored backward probabilities and forward probabilities as initial values. It should be noted that the fact that decoding processing is executed in parallel block by block in (1) and (2) also is new.

In the third embodiment, the decoding processing of each of the blocks is executed in parallel (the upper half of Fig. 6). More specifically, backward-probability calculation means for each block calculates backward probabilities in each of the blocks, namely block BL1 from L to 0, block BL2 from 2L to L, block BL3 from 3L to 2L, block BL4 from 4L to 3L, block BL5 from 5L to 4L, ⋯, in order in parallel fashion from data positions (initial positions) backward of each block using fixed values as initial values, thereby obtaining backward probabilities at the starting points of each of the blocks. (This represents backward-probability training.) For example, backward probabilities are trained (calculated) in order in parallel fashion from data positions 2L, 3L, 4L, 5L, 6L, ⋯ backward of each of the blocks to obtain backward probabilities at starting points L, 2L, 3L, 4L, 5L, ⋯ of each of the blocks. Thereafter, the backward probabilities of each of the blocks are calculated in parallel using the backward probabilities at the starting points of these blocks, and the calculated backward probabilities are stored. Furthermore, the values of backward probabilities $\beta_0$, $\beta_L$, $\beta_{2L}$, $\beta_{3L}$, $\beta_{4L}$, ⋯ at final data positions 0, L, 2L, 3L, 4L, ⋯ of each of the blocks are stored as initial values of backward probabilities for the next time. (In actuality, $\beta_0$, $\beta_L$ are not used.) That is, the final backward probability $\beta_{JL}$ of the (j+2)th block is stored as the initial value of backward probability of the jth block in decoding processing the next time.

In parallel with the above, forward-probability calculation means for each block calculates forward probabilities in each of the blocks, namely block BL1 from L to 0, block BL2 from 2L to L, block BL3 from 3L to 2L, block BL4 from 4L to 3L, block BL5 from 5L to 4L, ⋯, in order in parallel fashion from data positions (initial positions) ahead of each block using fixed values an initial values, thereby obtaining forward probabilities at the starting points of each of the blocks. (This represents forward-probability training. However, training is not performed in block BL1.) For example, forward probabilities are trained (calculated) in order in parallel fashion from data positions 0, L, 2L, 3L, 4L, ⋯ ahead of each of the blocks BL2, BL3, BL4, BL5, ⋯, forward probabilities of each of the blocks are calculated in parallel and decoding processing of the data of each of the blocks is executed in parallel using these forward probabilities and the stored backward probabilities.

Further, the values of forward probabilities $\alpha_L$, $\alpha_{2L}$, $\alpha_{3L}$, $\alpha_{4L}$, $\alpha_{5L}$, ⋯ at final data positions L, 2L, 3L, 4L, 5L ⋯ in each of the blocks, namely block BL1 from 0 to L, block BL2 from L to 2L, block BL3 from 2L to 3L, block BL4 from 3L to 4L, block BL5 from 4L to 5L, ⋯, are stored as initial values of forward probabilities for the next time. That is, the final forward probability $\alpha_{JL}$ of the jth block is stored as the initial value of forward probability of the (j+2)th block in decoding processing the next time.

In the second execution of decoding processing (the lower half of Fig. 6), the arithmetic unit of each block performs training using the stored backward probabilities $\beta_{2L}$, $\beta_{3L}$, $\beta_{4L}$ ⋯ as initial values and thereafter calculates the backward probabilities of block BL1 from L to 0, block BL2 from 2L to L, block BL3 from 3L to 2L, block BL4 from 4L to 3L, ⋯. Similarly, the arithmetic unit performs training using the stored forward probabilities $\alpha_L$, $\alpha_{2L}$, $\alpha_{3L}$, $\alpha_{4L}$ ⋯ as initial values and thereafter calculates the forward probabilities of block BL1 from 0 to L, block BL2 from L to 2L, block BL3 from 2L to 3L, block BL4 from 3L to 4L, ⋯ and performs a soft-decision operation.

Furthermore, in the second execution of decoding processing, values of backward probabilities $\beta_0'$, $\beta_L'$, $\beta_{2L}'$, $\beta_{3L}'$, $\beta_{4L}'$, ⋯ of final data 0, L, 2L, 3L, 4L, ⋯ in each of the blocks are stored as initial values of backward probabilities for the next time. Further, forward probabilities $\alpha_L'$, $\alpha_{2L}'$, $\alpha_{3L}'$, $\alpha_{4L}'$, ⋯ of final data L, 2L, 3L, 4L, ⋯ in each of the blocks are stored as initial values of forward probabilities for the next time.

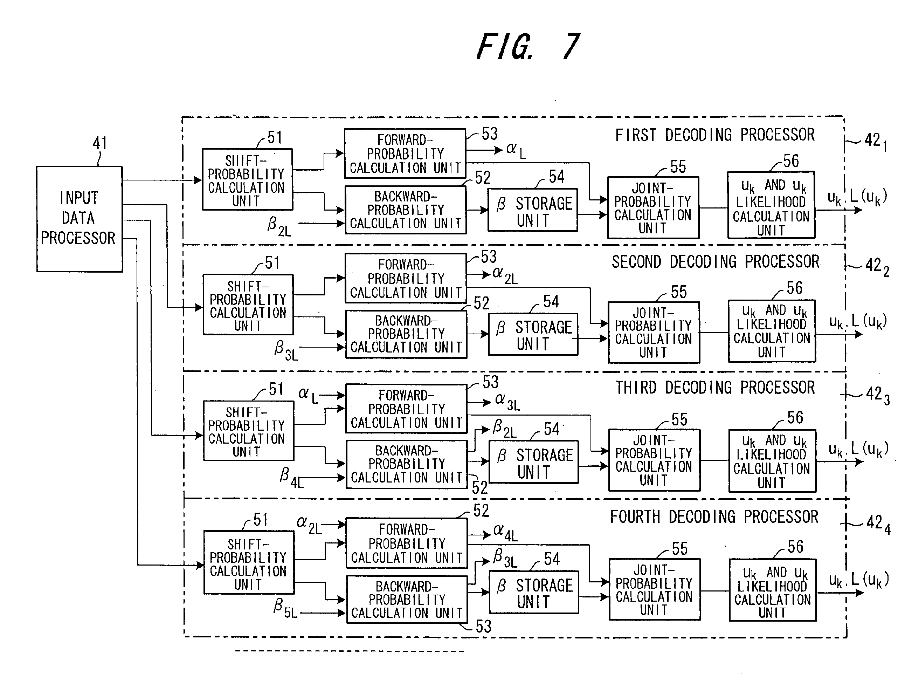

Fig. 7 is a block diagram of a maximum a posteriori probability decoding apparatus according to the third embodiment. Here an input data processor 41 extracts the necessary part of N items of encoded data that have been stored in memory (not shown) and inputs the extracted data to decoding processors $42_1$, $42_2$, $42_3$, $42_4$, ⋯ provided for respective ones of jth blocks (j = 1, 2, 3 ⋯).

Each of the decoding processors $42_1$, $42_2$, $42_3$, $42_4$, ⋯ is identically constructed and has a shift-probability calculation unit 51, a backward-probability calculation unit 52, a forward-probability calculation unit 53, a β storage unit 54, a joint-probability calculation unit 55 and a $u_k$ and $u_k$ likelihood calculation unit 56.

The forward-probability calculation unit 53 of the jth decoding processor $42_j$ of the jth block stores forward probability $\alpha_{JL}$ conforming to final data jL of the jth block in a storage unit (not shown) and inputs it to the forward-probability calculation unit 53 of the (j+2)th decoding processor $42_{j+2}$ as the initial value of the next forward probability calculation.

Further, the backward-probability calculation unit 52 of the (j+2)th decoding processor $42_{j+2}$ of the (j+2)th block stores backward probability $\beta_{(j+1)L}$ conforming to final data (j+1) of the (j+2)th block in a storage unit (not shown) and inputs it to the backward-probability calculation unit 52 of the jth decoding processor $42_j$ as the initial value of the next forward probability calculation.

The maximum a posteriori probability decoding apparatus according to the third embodiment executes decoding processing of each of the blocks in parallel in accordance with the time chart of Fig. 6, stores forward probabilities and backward probabilities obtained in the course of calculation as initial values for calculations the next time, and uses the stored backward probabilities and forward probabilities as initial values in calculations the next time.

Thus, in the third embodiment, forward and backward probabilities are both calculated using training data in metric calculation of each sub-block, whereby all sub-blocks can be processed in parallel. This makes high-speed MAP decoding possible. Further, in the second execution of decoding processing onward, forward and backward probabilities calculated and stored one execution earlier are used as initial values in calculations of forward and backward probabilities, respectively, and therefore highly precise decoding processing can be executed.

(E) Fourth Embodiment

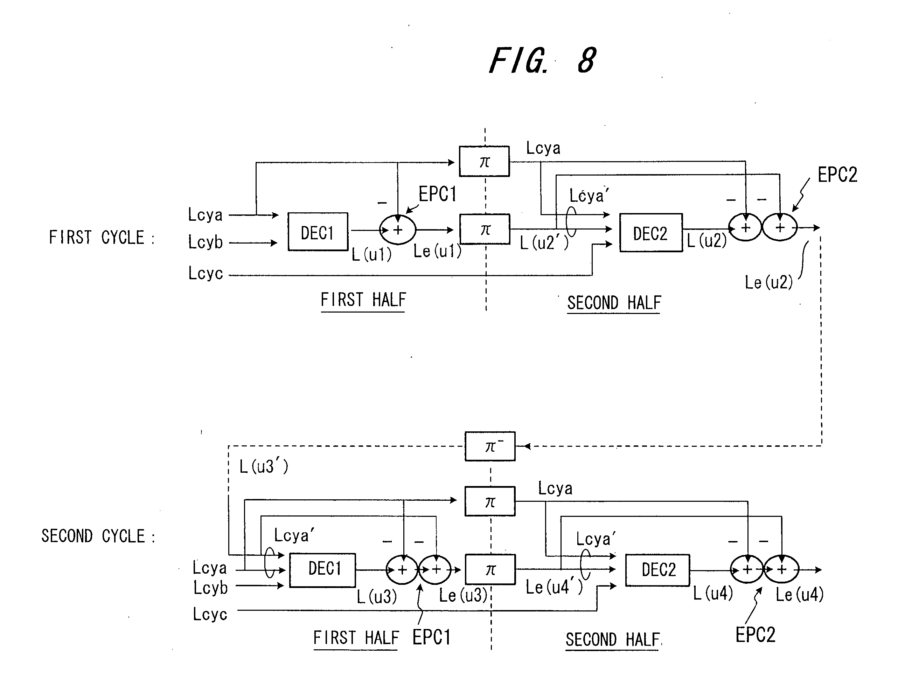

Fig. 8 is a diagram useful in describing the sequence of turbo decoding to which the present invention can be applied. As is obvious from Fig. 8, turbo decoding is repeated a plurality of times treating a first half of decoding, which uses ya, yb, and a second half of decoding, which uses ya, yc, as one set.

An external-information likelihood calculation unit EPC1 outputs external-information likelihood Le(u1) using a posteriori probability L(u) output in the first half of a first cycle of MAP decoding and the input signal ya to the MAP decoder. This external-information likelihood Le(u) is interleaved and output as a priori likelihood L(u2') used in the next half of MAP decoding.

In MAP decoding from the second cycle onward, turbo decoding is such that [signal ya + a priori likelihood L(u3')] is used as the input signal ya. Accordingly, in the second half of the first cycle of MAP decoding, an external-information likelihood calculation unit EPC2 outputs external-information likelihood Le(u2), which is used in the next MAP decoding, using the a posteriori likelihood L(u2) output from the element decoder DEC2 and the decoder input signal [= signal ya + a priori likelihood L(u2')]. This external-information likelihood Le(u2) is deinterleaved and output as a priori likelihood (u3') used in the next cycle of MAP decoding.

Thereafter, and in similar fashion, the external-information likelihood calculation unit EPC1 outputs external-information likelihood Le(u3) in the first half of the second cycle, and the external-information likelihood calculation unit EPC2 outputs external-information likelihood Le(u4) in the second half of the second cycle. In other words, the following equation is established using the log value of each value:

$$L(u) = Lya + L(u') + Le(u) \qquad (4)$$

The external-information likelihood calculation unit EPC1 therefore is capable of obtaining the external-information likelihood Le(u) in accordance with the following equation:

$$Le(u) = L(u) - Lya - L(u') \qquad (5)$$

where $L(u') = 0$ holds the first time.

To summarize, therefore, in the first half of decoding processing the first time, decoding is performed using receive signals Lcya, Lcyb and the likelihood $L(u_1)$ obtained is output. Next, the a priori probability $Le(u_1)$ is obtained in accordance with Equation (5) [where $L(u_1') = 0$ holds], this is interleaved and $L(u_2')$ is obtained.

In the second half of decoding processing the first time, a signal obtained by interleaving the receive signal cya and the a priori likelihood $L(u_2')$ obtained in the first half of decoding processing are regarded as being a new receive signal Lcya', decoding is performed using Lcya' and Lcyc, and the likelihood $(u_2)$ obtained is output. Next, the a priori likelihood $Le(u_2)$ is found in accordance with Equation (5) and this is deinterleaved to obtain $L(u_3')$.

In the first half of decoding processing the second time, the receive signal Lcya and the a priori likelihood $L(u_3')$ obtained in the second half of decoding processing are regarded as being a new receive signal Lcya', decoding is performed using Lcya' and Lcyb, and the likelihood $(u_3)$ obtained is output. Next, the a priori likelihood $Le(u_3)$ is found in accordance with the above equation, this is interleaved and $L(u_4')$ is obtained.

In the second half of decoding processing the second time, a signal obtained by interleaving the receive signal cya and the a priori likelihood $L(u_4')$ obtained in the first half of decoding processing are regarded as being a new receive signal Lcya', decoding is performed using Lcya' and Lcyc, and the likelihood $(u_4)$ obtained is output. Next, the a priori likelihood $Le(u_4)$ is found in accordance with Equation (5) and this is deinterleaved to obtain $L(u_5')$. The above-described decoding processing is repeated.

In accordance with the present invention, when decoding of code of a high encoding rate using puncturing is performed in a turbo decoder, a substantial encoding length can be assured and deterioration of characteristics prevented even if the length of a training portion in calculation of metrics is reduced. Furthermore, amount of calculation by the turbo decoder and the amount of memory used can be reduced. The invention therefore is ideal for utilization in MAP decoding by a turbo decoder or the like. It should be noted that the invention of this application is applicable to a MAP decoding method for performing not only the decoding of turbo code but also similar repetitive decoding processing.

As many different embodiments of the present invention can be made without departing from the scope thereof, it is to be understood that the invention is not limited to the specific embodiments thereof except as defined in the appended claims.

**Claims**

1. A decoding method of maximum a posteriori probability for calculating backward probabilities from a backward direction to a forward direction with regard to received data, calculating forward probabilities from a forward direction to a backward direction with regard to the received data, executing decoding processing based upon the backward probabilities and the forward probabilities, and repeating this decoding processing, said method comprising the steps of:

storing values of forward probabilities and/or backward probabilities, which have been calculated during decoding processing and prevail at calculation starting points, as initial values of forward probabilities and/or backward probabilities in decoding processing to be executed next; and
starting calculation of forward probabilities and/or backward probabilities using the stored initial values in decoding processing executed next.

2. The method according to claim 1, wherein the decoding processing includes the steps of:

dividing encoded data of length N into blocks each of a prescribed length L;
when backward probabilities of a prescribed block are calculated, starting calculation of backward probabilities from a data position backward of this block, obtaining the backward probabilities of this block and storing the backward probabilities;
then calculating forward probabilities and executing decoding processing of each data item in a block of interest using the forward probabilities and the stored backward probabilities; and
thenceforth executing decoding processing of each block in similar fashion.

3. A decoding method of maximum a posteriori probability for dividing data of length N into blocks each of a prescribed length L, calculating backward probabilities from a data position, which is an initial position, backward of a block of interest when backward probabilities of the block of interest are calculated, obtaining and storing the backward probabilities of the block of interest, then calculating forward probabilities, executing decoding processing of each data item of the block of interest using the forward probabilities and the stored backward probabilities and thenceforth executing decoding processing of each block in regular order, said method comprising the steps of:

storing backward probability, which prevails at the initial position of another block and is obtained in current decoding processing of each block, as an initial value of backward probability of the other block in decoding processing to be executed next; and
starting calculation of backward probabilities of each block using the stored initial value in decoding processing executed next.

4. The method according to claim 3, wherein the initial position is a position that is one block backward of the block of interest.

5. A decoding method of maximum a posteriori probability for dividing data of length N into blocks each of a prescribed length L, calculating backward probabilities from a data position, which is an initial position, backward of a block of interest when backward probabilities of the block of interest are calculated, obtaining and storing the backward probabilities of the block of interest, then calculating forward probabilities, executing decoding processing of each data item of the block of interest using the forward probabilities and the stored backward probabilities and thenceforth executing decoding processing of each block in regular order, said method comprising the steps of:

storing backward probability, which prevails at a starting point of another block and is obtained in current decoding processing of each block, as an initial value of backward probability of the other block in decoding processing to be executed next; and
in decoding processing of each block executed next, starting calculation of backward probabilities from the starting point of said block using the stored initial value.

6. The method according to claim 5, wherein decoding by sliding window method is executed only in initial decoding processing of each block.

7. The method according to claim 5 or 6, wherein the initial position is a position that is one block backward of the block of interest.

8. The method according to claim 7, wherein a final backward probability $\beta_{jL}$ of a (j+1)th block is adopted as the initial value of backward probability of a jth block in decoding processing executed next.

9. A decoding method of maximum a posteriori probability for calculating backward probabilities from a backward direction to a forward direction with regard to received data, calculating forward probabilities from a forward direction to a backward direction with regard to the received data, executing decoding processing based upon the backward probabilities and the forward probabilities, and repeating this decoding processing, said method comprising the steps of:

dividing data of length N into blocks each of a prescribed length L and executing, in parallel simultaneously for all blocks, processing for calculating backward probabilities from a data position, which is a backward-probability initial position, backward of each block, obtaining the backward probabilities of this block and storing this backward probabilities;

when forward probabilities of each block are calculated, executing, in parallel simultaneously for all blocks, processing for calculating forward probabilities from a data position, which is a forward-probability initial position, ahead of this block and obtaining the forward probabilities of this block;

executing decoding processing of data of each block in parallel using the forward probabilities of each block and the stored backward probabilities of each block;

storing a backward probability, which prevails at a backward-probability initial position of another block and is obtained in current decoding processing of each block, as an initial value of backward probability of the other block in decoding processing to be executed next, and storing a forward probability, which prevails at a forward-probability initial position of another block and is obtained in current decoding processing of each block, as an initial value of forward probability of the other block in decoding processing to be executed next; and

starting calculation of backward probabilities and forward probabilities of each block in parallel using the stored initial values in decoding processing executed next.

10. The method according to claim 9, wherein the backward-probability initial position is a position one block backward of a block of interest, and the forward-probability initial position is a position one block ahead of a block of interest.

11. The method according to claim 10, wherein a final backward probability $\beta_{jL}$ of a (j+2)th block is adopted as the initial value of backward probability of a jth block in decoding processing executed next; and

a final forward probability $\alpha_{jL}$ of a jth block is adopted as the initial value of forward probability of a (j+2)th block in decoding processing executed next.

12. A maximum a posteriori probability decoding apparatus for calculating backward probabilities from a backward direction to a forward direction with regard to received encoded data, calculating forward probabilities from a forward direction to a backward direction with regard to the received encoded data, executing decoding processing based upon the backward probabilities and the forward probabilities, and repeating this decoding processing, said apparatus comprising:

calculation means for calculating forward probabilities and backward probabilities using encoded data;

means for decoding the encoded data using the forward probabilities and backward probabilities; and

means for storing values of forward probabilities and/or backward probabilities, which have been calculated during decoding processing and prevail at calculation starting points, as initial values of forward probabilities and/or backward probabilities in decoding processing to be executed next;

wherein said calculation means starts calculation of forward probabilities and/or backward probabilities using the stored initial values in decoding processing executed next.

13. A maximum a posteriori probability decoding apparatus for dividing encoded data of length N into blocks each of a prescribed length L, calculating backward probabilities from a data position, which is an initial position, backward of a block of interest when backward probabilities of the block of interest are calculated, obtaining and storing the backward probabilities of the block of interest, then calculating forward probabilities, executing decoding processing of each data item of the block of interest using the forward probabilities and the stored backward probabilities and thenceforth executing decoding processing of each block in regular order, said apparatus comprising:

calculation means for calculating forward probabilities and backward probabilities using encoded data;

means for decoding the encoded data using the forward probabilities and backward probabilities; and

means for storing backward probability, which prevails at the initial position of another block and is obtained in current decoding processing of each block, as an initial value of backward probability of the other block in decoding processing to be executed next;

wherein said calculation means starts calculation of backward probabilities of each block using the stored initial value in decoding processing executed next.

14. A maximum a posteriori probability decoding apparatus for dividing encoded data of length N into blocks each of a prescribed length L, calculating backward probabilities from a data position, which is an initial position, backward of a block of interest when backward probabilities of the block of interest are calculated, obtaining and storing the backward probabilities of the block of interest, then calculating forward probabilities, executing decoding processing of each data item of the block of interest using the forward probabilities and the stored backward probabilities and thenceforth executing decoding processing of each block in regular order, said apparatus comprising:

calculation means for calculating forward probabilities and backward probabilities using encoded data;
means for decoding the encoded data using the forward probabilities and backward probabilities; and
means for storing a backward probability, which prevails at a starting point of another block and is obtained in current decoding processing of each block, as an initial value of backward probability of the other block in decoding processing to be executed next;

wherein said calculation means starts calculation of backward probabilities from the starting point of each block using the stored initial value in decoding processing of each block executed next.

15. A maximum a posteriori probability decoding apparatus for calculating backward probabilities from a backward direction to a forward direction with regard to received data, calculating forward probabilities from a forward direction to a backward direction with regard to the received data, executing decoding processing based upon the backward probabilities and the forward probabilities, and repeating this decoding processing, said apparatus comprising the following for every block when encoded data of length N has been divided into blocks each of a prescribed length L:

a backward-probability calculation unit for calculating backward probabilities;
a forward-probability calculation unit for calculating forward probabilities; and
decoding means for decoding the data using the forward probabilities and backward probabilities;

wherein said backward-probability calculation unit for each block executes, in parallel simultaneously for all blocks, processing for calculating backward probabilities from a data position, which is a backward-probability initial position, backward of each block, obtaining the backward probabilities of this block and storing this backward probabilities;
said forward-probability calculation unit for each block executes, in parallel simultaneously for all blocks, processing for calculating forward probabilities from a data position, which is a forward-probability initial position, ahead of this block; and
said decoding means executes decoding processing of data of each block in simultaneously using the forward probabilities of each block and the stored backward probabilities of each block.

16. The apparatus according to claim 15, further comprising:

first storage means for storing a backward probability, which prevails at a prescribed position of another block and is obtained in decoding processing of each block; and
second storage means for storing a forward probability, which prevails at a prescribed position of another block and is obtained in decoding processing of each block;

wherein said first storage means stores backward probability, which prevails at the backward-probability initial position of another block and is obtained in current decoding processing of each block, as an initial value of backward probability of the other block in decoding processing to be executed next;
said second storage means stores forward probability, which prevails at the forward-probability initial position of another block and is obtained in current decoding processing of each block, as an initial value of forward probability of the other block in decoding processing to be executed next; and
said backward-probability calculation unit and said forward-probability calculation unit of each block start calculation of backward probabilities and forward probabilities of each block in parallel using the stored initial values in decoding processing executed next.

# FIG. 1

EP 1 521 374 A1

# FIG. 2

F/G. 3

INPUT DATA

O : INITIAL VALUE

A : FORWARD PROBABILITY CALCULATION
B : BACKWARD PROBABILITY CALCULATION
S : SOFT-DECISION OPERATION

● : PREVIOUS LOOP VALUE

INPUT DATA

EXECUTION TIMING

EXECUTION TIMING

*FIG. 4*

FORWARD-
PROBABILITY
CALCULATION
UNIT
25

INPUT DATA
PROCESSOR
21

SHIFT-
PROBABILITY
CALCULATION
UNIT
22

FIRST
BACKWARD-
PROBABILITY
CALCULATION
UNIT
23

β STORAGE
UNIT
26

β INITIAL-
VALUE
SETTING
UNIT
32

β INITIAL-
VALUE
STORAGE
UNIT
27

$\beta_{2L},$
$\beta_{3L},$
$\vdots$
$\beta_{N-1L}$

SELECTOR
29

JOINT-
PROBABILITY
CALCULATION
UNIT
30

$u_k$ AND $u_k$
LIKELIHOOD
CALCULATION
UNIT
31

$u_k$

$L(u_k)$

SECOND
BACKWARD-
PROBABILITY
CALCULATION
UNIT
24

β STORAGE
UNIT
28

TIMING
CONTROL UNIT
20

20

# FIG. 5

|← BL1 →|← BL2 →|← BL3 →|← BL4 →|← BL5 →|← BL6 →|

L  2L  3L  4L  N

INPUT DATA

○ : INITIAL VALUE

A : FORWARD PROBABILITY CALCULATION
B : BACKWARD PROBABILITY CALCULATION
S : SOFT-DECISION OPERATION

EXECUTION TIMING

INPUT DATA

● : PREVIOUS LOOP VALUE

EXECUTION TIMING

EP 1 521 374 A1

FIG. 6

## FIG. 7

# FIG. 8

FIRST CYCLE :

Lcya
Lcyb
Lcyc

DEC1
L(u1)  −  EPC1  +  Le(u1)  π  L(u2′)
π  Lcya

FIRST HALF

Lcya′  DEC2  L(u2)  +  −  +  −  EPC2
Le(u2)

SECOND HALF

SECOND CYCLE :

π⁻

L(u3′)

π  Lcya

Lcya′

Lcya
Lcyb
Lcyc

DEC1  L(u3)  +  −  +  −  Le(u3)  π  Le(u4′)

FIRST HALF  EPC1

Lcya′  DEC2  L(u4)  +  −  +  −
Le(u4)

SECOND HALF  EPC2

EP 1 521 374 A1

## FIG. 9 PRIOR ART

$g_0$

EXOR1

+

INPUT INFORMATION

01101

Ro

R1

SFR

EXOR2

+

$g_1$

## FIG. 10 PRIOR ART

| INPUT | INITIAL STATE | SHIFT REGISTER | | | OUTPUT | |
|---|---|---|---|---|---|---|
| | | 0 | 0 | | $g_0$ | $g_1$ |
| 0 | → | 0 | 0 | → | 0 | 0 |
| 1 | → | 1 | 0 | → | 1 | 0 |
| 1 | → | 1 | 1 | → | 0 | 1 |
| 0 | → | 0 | 1 | → | 1 | 1 |
| 1 | → | 1 | 0 | → | 1 | 0 |

state

## FIG. 11 PRIOR ART

| $m_0$ | $m_1$ | $m_2$ | $m_3$ |
|---|---|---|---|
| 0 ¦ 0 | 0 ¦ 1 | 1 ¦ 0 | 1 ¦ 1 |

# FIG. 12 PRIOR ART

| STATE BEFORE DATA INPUT | OUTPUT | STATE AFTER DATA INPUT |
|---|---|---|
| (1) $m_0$ | 00 | $m_0$ |
|  | 11 | $m_2$ |
| (2) $m_1$ | 11 | $m_0$ |
|  | 00 | $m_2$ |
| (3) $m_2$ | 01 | $m_1$ |
|  | 10 | $m_3$ |
| (4) $m_3$ | 10 | $m_1$ |
|  | 01 | $m_3$ |

- - - → : 0 INPUT

———→ : 1 INPUT

# FIG. 13 PRIOR ART

FORWARD PROBABILITY $\alpha_{0,k}(m)$, $\alpha_{1,k}(m)$ : BACKWARD PROBABILITY $\beta_k(m)$

STATE

m=0

m=1

m=2

m=3

TIME 0    1    k-1    k    N

$k \longrightarrow$

(00) (11) (11) (00) (01) (10) (10) (01)

# FIG. 14 PRIOR ART

EP 1 521 374 A1

STATE

STATE

STATE

| $\alpha_{1,k}(0)$ (PROBABIL-ITY OF 1) | $\alpha_{0,k}(0)$ (PROBABIL-ITY OF 0) | |
|---|---|---|
| $\alpha_{1,1}$ | $\alpha_{0,1}$ | |
| $\alpha_{1,2}$ | $\alpha_{0,2}$ | |
| $\vdots$ | $\vdots$ | $\vdots$ |
| $\alpha_{1,N}$ | $\alpha_{0,N}$ | |

$\alpha_{1,k}(3)$  $\alpha_{0,k}(3)$

4a   4d

**1** SHIFT-PROBABILITY CALCULATION UNIT

$y_{ak}$ →
$y_{bk}$ →

$\gamma_{0,k} \sim \gamma_{3,k}$

**3** FORWARD-PROBABILITY CALCULATION UNIT

$\alpha_{1,k}$

$\alpha_{0,k}$

DELAY

DELAY

$\alpha_{0,k-1}$

$\alpha_{1,k-1}$

**2**

| $\gamma_{0,k}$ (0,0) | $\gamma_{1,k}$ (0,1) | $\gamma_{2,k}$ (1,0) | $\gamma_{3,k}$ (1,1) |
|---|---|---|---|
| $\gamma_{0,1}$ | $\gamma_{1,1}$ | $\gamma_{2,1}$ | $\gamma_{3,1}$ |
| $\gamma_{0,2}$ | $\gamma_{1,2}$ | $\gamma_{2,1}$ | $\gamma_{3,1}$ |
| $\vdots$ | $\vdots$ | $\vdots$ | $\vdots$ |
| $\gamma_{0,N}$ | $\gamma_{1,N}$ | $\gamma_{2,N}$ | $\gamma_{3,N}$ |

$\gamma_{0,k+1} \sim \gamma_{3,k+1}$

**5** BACKWARD-PROBABILITY CALCULATION UNIT

$\beta_k(m)$

DELAY

$\beta_{k+1}$

$\alpha_{0,k}(m)$

$\alpha_{1,k}(m)$

**6a** 1 JOINT-PROBABILITY CALCULATION

$\lambda_{1,k}(m)$

**6b** 0 JOINT-PROBABILITY CALCULATION

$\lambda_{0,k}(m)$

6

**7** $u_k$ AND $u_k$ LIKELIHOOD CALCULATION UNIT

→ $L(u_k)$

$u_k$

# FIG. 15 PRIOR ART

$y_a \rightarrow$ , $y_b \rightarrow$ INPUT/OUTPUT REVERSER (8) $\rightarrow$ SHIFT-PROBABILITY CALCULATION UNIT (1) $\rightarrow$ MEMORY (2) $\rightarrow$ FORWARD-PROBABILITY CALCULATION UNIT (3)

$\alpha_{0,k}(m), \alpha_{1,k}(m)$

BACKWARD-PROBABILITY CALCULATION UNIT (5) $\rightarrow$ MEMORY (9) $\xrightarrow{\beta_k(m)}$ JOINT-PROBABILITY CALCULATION UNIT (6) $\xrightarrow{\lambda_{1,k}(m)}$ $\xrightarrow{\lambda_{0,k}(m)}$ $u_k$ AND $u_k$ LIKELIHOOD CALCULATION UNIT (7) $\xrightarrow{L(u_k)}$ $\xrightarrow{u_k}$

# FIG. 16 PRIOR ART

{
- CALCULATE SHIFT PROBABILITY
- WRITE TO MEMORY 2
- CALCULATE BACKWARD PROBABILITY
- WRITE TO MEMORY 9
}

$\longleftarrow N \longrightarrow$

{
- READ MEMORY 2
- CALCULATE FORWARD PROBABILITY
- READ MEMORY 9
- CALCULATE JOINT PROBABILITY
- CALCULATE $u_k$ AND $u_k$ LIKELIHOOD
}

$\longleftarrow N \longrightarrow$

FIG. 17 PRIOR ART

A : FORWARD PROBABILITY CALCULATION
B : BACKWARD PROBABILITY CALCULATION
S : SOFT-DECISION OPERATION

FIG. 18 PRIOR ART

# FIG. 19A  PRIOR ART

B OPERATION

A OPERATION

# FIG. 19B  PRIOR ART

FIRST B OPERATION

SECOND B OPERATION

A OPERATION

# FIG. 20 PRIOR ART

○ : INITIAL VALUE

A : FORWARD PROBABILITY CALCULATION
B : BACKWARD PROBABILITY CALCULATION
S : SOFT-DECISION OPERATION

EXECUTION TIMING

EP 1 521 374 A1

European Patent
Office

**EUROPEAN SEARCH REPORT**

Application Number

EP 04 25 1723

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2003/097630 A1 (GATHERER ALAN ET AL) 22 May 2003 (2003-05-22) * abstract * * page 2, paragraph 26 * * page 3, paragraph 32 - paragraph 33 * * paragraph [0051] - paragraph [0052] * * figures 6,7 * ----- | 1-16 | H03M13/29 |
| X | YOON S ET AL: "A parallel MAP algorithm for low latency Turbo decoding" IEEE COMMUNICATIONS LETTERS, vol. 6, no. 7, July 2002 (2002-07), pages 288-290, XP001123683 ISSN: 1089-7798 * abstract * * page 289, left-hand column, paragraph 3 * * figure 2 * ----- | 1,3,5-9, 12-16 | |
| X | DIELISSEN J. AND HUISKEN J.: "State vector initialization of sliding window MAP" PROC. 2ND INTERNATIONAL SYMPOSIUM ON TRUBO CODES AND RELATED TOPICS, BREST, FRANCE 2000, 4 September 2000 (2000-09-04), - 7 September 2000 (2000-09-07) pages 387-390, XP009039864 * page 387, right-hand column * ----- -/-- | 1,3,5-8, 12-14 | **TECHNICAL FIELDS SEARCHED** (Int.Cl.7) H03M |

The present search report has been drawn up for all claims

| Place of search | Date of completion of the search | Examiner |
|---|---|---|
| Munich | 15 November 2004 | Offer, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                             

& : member of the same patent family, corresponding document

EPO FORM 1503 03.82 (P04C01)

**European Patent Office**

**EUROPEAN SEARCH REPORT**

Application Number

EP 04 25 1723

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | BOUTILLON E ET AL: "VLSI architectures for the MAP algorithm" IEEE TRANSACTIONS ON COMMUNICATIONS, vol. 51, no. 2, February 2003 (2003-02), pages 175-185, XP001164390 ISSN: 0090-6778 * page 182, right-hand column - page 183, left-hand column * * page 184, left-hand column, paragraph 2 * * figures 10,11 * | 1,3,5-8, 12-14 | |
| X | RAOUAFI F ET AL: "Saving memory in turbo-decoders using the Max-Log-MAP algorithm" PROC., IEE COLLOQUIUM. TURBO CODES IN DIGITAL BROADCASTING - COULD IT BE DOUBLE CAPACITY, 22 November 1999 (1999-11-22), pages 14-1-14-4, XP002185687 * pages 14-3; figure 4 * | 1,3,5-8, 12-14 | TECHNICAL FIELDS SEARCHED (Int.Cl.7) |

The present search report has been drawn up for all claims

| Place of search | Date of completion of the search | Examiner |
|---|---|---|
| Munich | 15 November 2004 | Offer, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 04 25 1723

This annex lists the patent family members relating to the patent documents cited in the above-mentioned European search report.
The members are as contained in the European Patent Office EDP file on
The European Patent Office is in no way liable for these particulars which are merely given for the purpose of information.

15-11-2004

| Patent document cited in search report | Publication date | Patent family member(s) | Publication date |
|---|---|---|---|
| US 2003097630 A1 | 22-05-2003 | NONE | |

EPO FORM P0459

For more details about this annex : see Official Journal of the European Patent Office, No. 12/82